# EUROPEAN PATENT APPLICATION

(11) **EP 4 633 325 A1**
(43) Date of publication of application: **15.10.2025**
(21) Application number: 25152242.1
(22) Date of filing: 16.01.2025
(51) Int. Cl.: H10D 64/01, H10D 30/00, H10D 30/67, H10D 64/23

(54) **SEMICONDUCTOR DEVICE**

(30) Priority: 11.04.2024 KR 20240048685
(71) Applicant: Samsung Electronics Co., Ltd., Suwon-si, Gyeonggi-do 16677 (KR)
(72) Inventor: CHOI, Woo Suk, 16677 Suwon-si (KR); NOH, Chang Woo, 16677 Suwon-si (KR); PARK, Beom Jin, 16677 Suwon-si (KR); KANG, Myung Gil, 16677 Suwon-si (KR); KIM, Dong Won, 16677 Suwon-si (KR)
(74) Representative: Marks & Clerk LLP

(57) **Abstract**

A semiconductor device includes a lower interlayer insulating layer, an insulating pattern extending in a first direction on an upper surface of the lower interlayer insulating layer, an active pattern extending in the first direction on an upper surface of the insulating pattern, a plurality of nanosheets stacked in a third direction on an upper surface of the active pattern, a gate electrode extending in a second direction on the upper surface of the active pattern, a first source/drain region on a first side of the gate electrode, a second source/drain region on a second side of the gate electrode opposite to the first side of the gate electrode in the first direction, and a lower source/drain contact extending through the lower interlayer insulating layer, the insulating pattern, and the active pattern in the third direction.

## Description

### BACKGROUND

### 1. Technical Field

The present disclosure relates to a semiconductor device. Specifically, the present disclosure relates to a semiconductor device including a MBCFET^{™} (Multi-Bridge Channel Field Effect Transistor).

### 2. Description of the Related Art

One of the scaling technologies for increasing density of an integrated circuit device involves the use of a multi-gate transistor in which a silicon body of a fin or nanowire shape is formed on a substrate and a gate is formed on a surface of the silicon body.

Because such a multi gate transistor utilizes a three-dimensional channel, scaling may be more easily performed. Further, even if a gate length of the multi-gate transistor is not increased, the current control capability may be improved. Furthermore, a SCE (short channel effect) in which potential of a channel region is influenced by a drain voltage may be effectively suppressed.

### SUMMARY

Aspects of the present disclosure provide a semiconductor device in which a source/drain region is electrically insulated from an active pattern by using a buried insulating pattern and/or an insulating liner layer disposed between the source/drain region, to which a lower source/drain contact is electrically connected, and the active pattern. By insulating the source/drain region from the active pattern, a leakage path may be blocked. For instance, a leakage path may be formed along the active pattern between two source/drain regions. Providing one or more buried insulating patterns to insulate one or both of the source/drain regions from the active pattern can therefore prevent a leakage current. Therefore, the semiconductor device according to some embodiments of the present disclosure may improve the reliability of the source/drain regions, and in particular, may improve the reliability of the source/drain region electrically connected to the lower source/drain contact.

According to some embodiments of the present disclosure, there is provided a semiconductor device, comprising a lower interlayer insulating layer, an insulating pattern extending in a first direction on an upper surface of the lower interlayer insulating layer, an active pattern extending in the first direction on an upper surface of the insulating pattern, the active pattern including silicon (Si), a plurality of nanosheets spaced apart from each other and stacked in a third direction on an upper surface of the active pattern, a gate electrode extending in a second direction on the upper surface of the active pattern, the gate electrode surrounding the plurality of nanosheets, in a cross-sectional view of the semiconductor device taken along the first direction, the first and second directions being perpendicular to one another and forming a plane, the third direction being perpendicular to the plane, a first source/drain region on a first side of the gate electrode, a second source/drain region on a second side of the gate electrode opposite to the first side of the gate electrode in the first direction, at least a part of the second source/drain region overlapping the active pattern in the third direction, the second source/drain region not being in contact with the active pattern, and a lower source/drain contact extending through the lower interlayer insulating layer, the insulating pattern, and the active pattern in the third direction, the lower source/drain contact being electrically connected to the second source/drain region.

According to some embodiments of the present disclosure, there is provided a semiconductor device, comprising a lower interlayer insulating layer, an insulating pattern extending in a first direction on an upper surface of the lower interlayer insulating layer, an active pattern extending in the first direction on an upper surface of the insulating pattern, the active pattern including silicon (Si), a field insulating layer surrounding a side wall of the insulating pattern and a side wall of the active pattern on the upper surface of the lower interlayer insulating layer in a plan view of the semiconductor device, a gate electrode extending in a second direction on an upper surface of the active pattern and an upper surface of the field insulating layer, the first and second directions being perpendicular to one another and forming a plane, a first source/drain region on a first side of the gate electrode, a second source/drain region on a second side of the gate electrode opposite to the first side of the gate electrode in the first direction, the second source/drain region not being in contact with on the active pattern, a lower source/drain contact extending through the lower interlayer insulating layer, the insulating pattern, and the active pattern in a third direction that is perpendicular to the plane, the lower source/drain contact being electrically connected to the second source/drain region, a first buried insulating pattern being in contact with each of the upper surface of the insulating pattern and a lower surface of the first source/drain region, both side walls of the first buried insulating pattern in the first direction being in contact with the active pattern, the first buried insulating pattern including a same material as the insulating pattern, and a second buried insulating pattern on both side walls of the lower source/drain contact in the first direction, the second buried insulating pattern being in contact with each of a lower surface of the second source/drain region and the active pattern, the second buried insulating pattern including a same material as the insulating pattern.

According to some embodiments of the present disclosure, there is provided a semiconductor device, comprising a lower interlayer insulating layer, an insulating pattern extending in a first direction on an upper surface of the lower interlayer insulating layer, an active pattern extending in the first direction on an upper surface of the insulating pattern, the active pattern including silicon (Si), a field insulating layer surrounding a side wall of the insulating pattern and a side wall of the active pattern in a plan view of the semiconductor device on the upper surface of the lower interlayer insulating layer, a plurality of nanosheets spaced apart from each other and stacked in a third direction on an upper surface of the active pattern, a gate electrode extending in a second direction on the upper surface of the active pattern and an upper surface of the field insulating layer, the first and second directions being perpendicular to one another and forming a plane, the third direction being perpendicular to the plane, a first source/drain region on a first side of the gate electrode, a second source/drain region on a second side of the gate electrode opposite to the first side of the gate electrode in the first direction, at least a part of the second source/drain region overlapping the active pattern in the third direction, the second source/drain region not being in contact with on the active pattern, a lower source/drain contact extending through the lower interlayer insulating layer, the insulating pattern, and the active pattern in the third direction, the lower source/drain contact being electrically connected to the second source/drain region, a first buried insulating pattern being in contact with each of the upper surface of the insulating pattern and a lower surface of the first source/drain region, both side walls of the first buried insulating pattern in the first direction being in contact with the active pattern, the first buried insulating pattern including a same material as the insulating pattern, a second buried insulating pattern on both side walls of the lower source/drain contact in the first direction, the second buried insulating pattern being in contact with each of a lower surface of the second source/drain region and the active pattern, the second buried insulating pattern including a same material as the insulating pattern, an insulating liner layer surrounding a side wall of the lower source/drain contact on the lower surface of the second source/drain region in a plan view of the semiconductor device, at least a part of the insulating liner layer being between the lower source/drain contact and the second buried insulating pattern, the insulating liner layer including a material different from each of the lower interlayer insulating layer, the insulating pattern, and the second buried insulating pattern, and a lower silicide layer between the lower source/drain contact and the second source/drain region, the lower silicide layer being in contact with an upper surface of the insulating liner layer, wherein the upper surface of the insulating liner layer is formed on a same plane as an upper surface of the second buried insulating pattern, and wherein each of the first and second buried insulating patterns does not overlap the plurality of nanosheets in the third direction.

At least some of the above and other features of the invention are set out in the claims. However, aspects of the present disclosure are not restricted to the ones set forth herein. The above and other aspects of the present disclosure will become more apparent to one of ordinary skill in the art to which the present disclosure pertains by referencing the detailed description of the present disclosure given below.

### BRIEF DESCRIPTION OF THE DRAWINGS

The above and other aspects and features of the present disclosure will become more apparent by describing in detail example embodiments thereof with reference to the attached drawings, in which:
FIG. 1 is a layout diagram illustrating a semiconductor device according to some embodiments of the present disclosure;
FIG. 2 is a cross-sectional view taken along line A-A' of FIG. 1;
FIG. 3 is a cross-sectional view taken along line B-B' of FIG. 1;
FIG. 4 is a cross-sectional view taken along line C-C' of FIG. 1;
FIGS. 5 to 35 are intermediate process diagrams illustrating a method for fabricating a semiconductor device according to some embodiments of the present disclosure;
FIGS. 36 to 38 are cross-sectional views illustrating a semiconductor device according to some other embodiments of the present disclosure;
FIG. 39 is a cross-sectional view illustrating a semiconductor device according to some other embodiments of the present disclosure;
FIG. 40 is a cross-sectional view illustrating a semiconductor device according to still other embodiments of the present disclosure;
FIG. 41 is a cross-sectional view illustrating a semiconductor device according to still other embodiments of the present disclosure; and
FIG. 42 is a cross-sectional view illustrating a semiconductor device according to still other embodiments of the present disclosure.

### DETAILED DESCRIPTION OF THE EMBODIMENTS

Hereinafter, embodiments of the present disclosure will be described as follows with reference to the accompanying drawings in which example embodiments of the inventive concept are shown. The same reference numerals are used for the same elements in the drawings, and redundant descriptions thereof will be omitted. As used herein, the term "and/or" includes any and all combinations of one or more of the associated listed items. It will be understood that when an element is referred to as being "on," "attached" to, "connected" to, "coupled" with, "contacting," etc., another element, it can be directly on, attached to, connected to, coupled with or contacting the other element or intervening elements may also be present. In contrast, when an element is referred to as being, for example, "directly on," "directly attached" to, "directly connected" to, "directly coupled" with or "directly contacting" another element, there are no intervening elements present. It is noted that aspects described with respect to one embodiment may be incorporated in different embodiments although not specifically described relative thereto. That is, all embodiments and/or features of any embodiments can be combined in any way and/or combination. The phrase "for example" may be used herein to introduce particular features (e.g. example embodiments); however, it need not imply any link between those features and any preceding statements. For instance, the phrase "for example" may be replaced with "in one or more examples" or "in one or more embodiments".

In the following drawings of the semiconductor device according to some embodiments, although the semiconductor device will be described as including a transistor (e.g. a MBCFET^{™} (Multi-Bridge Channel Field Effect Transistor)) including a nanosheet as an example, embodiments of the present disclosure are not limited thereto. In some other embodiments, the semiconductor device may, of course, include a fin-type transistor (FinFET), a tunneling transistor (tunneling FET) or a three-dimensional (3D) transistor including a channel region of a fin-type pattern shape. In addition, the semiconductor device according to some embodiments may also include a bipolar junction transistor, a laterally diffused metal oxide semiconductor (LDMOS), or the like.

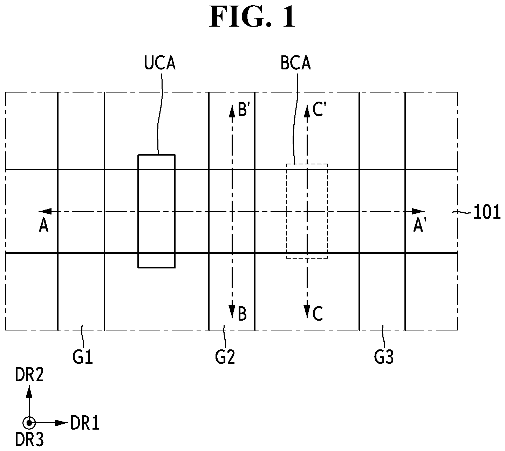

Hereinafter, the semiconductor device according to some embodiments of the present disclosure will be described with reference to FIGS. 1 to 4.

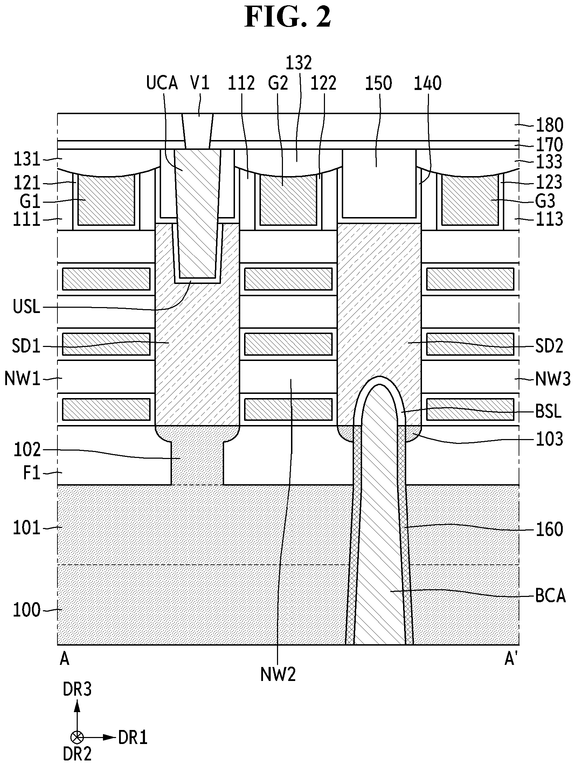

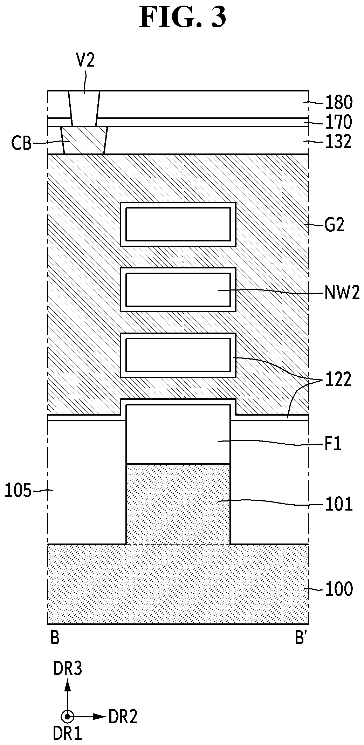

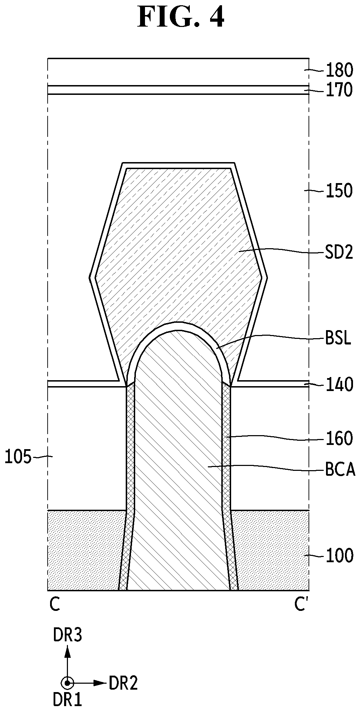

FIG. 1 is a layout diagram illustrating a semiconductor device according to some embodiments of the present disclosure. FIG. 2 is a cross-sectional view taken along line A-A' of FIG. 1. FIG. 3 is a cross-sectional view taken along line B-B' of FIG. 1. FIG. 4 is a cross-sectional view taken along line C-C' of FIG. 1.

Referring to FIGS. 1 to 4, the semiconductor device according to some embodiments of the present disclosure includes a lower interlayer insulating layer 100, an insulating pattern 101, an active pattern F1, first and second buried insulating patterns 102 and 103, a field insulating layer 105, first to third plurality of nanosheets NW1, NW2 and NW3, first to third gate electrodes G1, G2 and G3, first to third gate spacers 111, 112 and 113, first to third gate insulating layers 121, 122 and 123, first to third capping patterns 131, 132 and 133, first and second source/drain regions SD1 and SD2, a first etch stop layer 140, a first upper interlayer insulating layer 150, a gate contact CB, an upper source/drain contact UCA, a lower source/drain contact BCA, an upper silicide layer USL, a lower silicide layer BSL, an insulating liner layer 160, a second etch stop layer 170, a second upper interlayer insulating layer 180, and first and second vias V1 and V2.

The lower interlayer insulating layer 100 may include, for example, at least one of silicon oxide, silicon nitride, silicon oxynitride, and a low dielectric constant material. Although the low dielectric constant material may include, for example, at least one of Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate Glass), SiLK, Amorphous Fluorinated Carbon, silica aerogels, silica xerogels, mesoporous silica or combinations thereof, the present disclosure is not limited thereto. A low dielectric constant material may be a material having a dielectric constant that is lower than that of silicon oxide.

Hereinafter, each of a first horizontal direction DR1 (e.g. a first direction) and a second horizontal direction DR2 (e.g. a second direction) may be defined as a direction parallel to an upper surface of the lower interlayer insulating layer 100. The second horizontal direction DR2 may be defined as a direction different from the first horizontal direction DR1 and may be perpendicular to the first horizontal direction DR1. A vertical direction DR3 (e.g. a third direction) may be defined as a direction perpendicular to each of the first horizontal direction DR1 and the second horizontal direction DR2. That is, the vertical direction DR3 may be defined as a direction perpendicular to the upper surface of the lower interlayer insulating layer 100 or perpendicular to a plane formed by the first horizontal direction DR1 and the second horizontal direction DR2. It will be appreciated that the directions and positions defined herein are defined relative to the structure of the semiconductor device. Accordingly, whilst terms such as "horizontal", "vertical", "upper", "lower", etc. are used, it will be appreciated that these are defined relative to the structure of the semiconductor device and need not imply any particular orientation of the semiconductor device in use. The terms "first horizontal direction", "second horizontal direction" and "vertical direction" may be replaced with "first direction", "second direction" and "third direction", respectively.

The insulating pattern 101 may extend in the first horizontal direction DR1 on the upper surface of the lower interlayer insulating layer 100. The insulating pattern 101 may protrude from the upper surface of the lower interlayer insulating layer 100 in the vertical direction DR3. The lower surface of the insulating pattern 101 may be in contact with the upper surface of the lower interlayer insulating layer 100. The insulating pattern 101 may include an insulating material. For example, the insulating pattern 101 may include the same material as the lower interlayer insulating layer 100.

The active pattern F1 may extend in the first horizontal direction DR1 on the upper surface of the insulating pattern 101. A lower surface of the active pattern F1 may be in contact with an upper surface of the insulating pattern 101. For example, the active pattern F1 may overlap the insulating pattern 101 in the vertical direction DR3. For example, both side walls of the active pattern F1 in the second horizontal direction DR2 may be aligned with both side walls of the insulating pattern 101 in the second horizontal direction DR2. The active pattern F1 may include a material different from each of the lower interlayer insulating layer 100 and the insulating pattern 101. For example, the active pattern F1 may include silicon (Si).

The field insulating layer 105 may be disposed on the upper surface of the lower interlayer insulating layer 100. The field insulating layer 105 may surround side walls of each of the insulating pattern 101 and the active pattern F1 in a plan view of the semiconductor device. For example, the field insulating layer 105 may be in contact with the side walls of each of the insulating pattern 101 and the active pattern F1 in the second horizontal direction DR2. For example, the upper surface of the insulating pattern 101 may be formed to be lower than the upper surface of the field insulating layer 105 in the vertical direction DR3. For example, the upper surface of the active pattern F1 may be formed to be higher than the upper surface of the field insulating layer 105 in the vertical direction DR3. That is, at least a part of the active pattern F1 may protrude beyond the upper surface of the field insulating layer 105 in the vertical direction DR3. However, embodiments of the present disclosure are not limited thereto. In some other embodiments, the upper surface of the active pattern F1 may be formed on the same plane as the upper surface of the field insulating layer 105. The field insulating layer 105 may include, for example, an oxide film, a nitride film, an oxynitride film or a combination thereof.

The first plurality of nanosheets NW1 may be disposed on the upper surface of the active pattern F1. The first plurality of nanosheets NW1 may be disposed at a portion at which the active pattern F1 and the first gate electrode G1 intersect. The second plurality of nanosheets NW2 may be disposed on the upper surface of the active pattern F1. The second plurality of nanosheets NW2 may be disposed at a portion at which the active pattern F1 and the second gate electrode G2 intersect. The second plurality of nanosheets NW2 may be spaced apart from the first plurality of nanosheets NW1 in the first horizontal direction DR1. The third plurality of nanosheets NW3 may be disposed on the upper surface of the active pattern F1. The third plurality of nanosheets NW3 may be disposed at a portion at which the active pattern F1 and the third gate electrode G3 intersect. The third plurality of nanosheets NW3 may be spaced apart from the second plurality of nanosheets NW2 in the first horizontal direction DR1.

Each of the first to third plurality of nanosheets NW1, NW2, and NW3 may include a plurality of nanosheets spaced apart from each other and stacked in the vertical direction DR3. In FIG. 2 and FIG. 3, although each of the first to third plurality of nanosheets NW1, NW2, and NW3 is shown to include three nanosheets spaced apart from each other and stacked in the vertical direction DR3, this is only for convenience of explanation, and embodiments of the present disclosure are not limited thereto. In some other embodiments, each of the first to third nanosheets NW1, NW2, and NW3 may include four or more nanosheets spaced apart from each other and stacked in the vertical direction DR3. That is, any number of nanosheets may be utilized. As an example, each of the first to third nanosheets NW1, NW2, and NW3 may include silicon (Si). However, embodiments of the present disclosure are not limited thereto. In some other embodiments, each of the first to third nanosheets NW1, NW2, and NW3 may include silicon germanium (SiGe).

The first gate electrode G1 may extend in the second horizontal direction DR2 on the active pattern F1 and the field insulating layer 105. The first gate electrode G1 may surround the first plurality of nanosheets NW1 in a cross-sectional view of the semiconductor device taken along the first horizontal direction DR1. The second gate electrode G2 may extend in the second horizontal direction DR2 on the active pattern F1 and the field insulating layer 105. The second gate electrode G2 may surround the second plurality of nanosheets NW2 in a cross-sectional view of the semiconductor device taken along the first horizontal direction DR1. The second gate electrode G2 may be spaced apart from the first gate electrode G1 in the first horizontal direction DR1. The third gate electrode G3 may extend in the second horizontal direction DR2 on the active pattern F1 and the field insulating layer 105. The third gate electrode G3 may surround the third plurality of nanosheets NW3 in a cross-sectional view of the semiconductor device taken along the first horizontal direction DR1. The third gate electrode G3 may be spaced apart from the second gate electrode G2 in the first horizontal direction DR1.

Each of the first to third gate electrodes G1, G2, and G3 may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlCN), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof. Each of the first to third gate electrodes G1, G2, and G3 may include a conductive metal oxide, conductive metal oxynitride, or the like, and may include an oxidized form of the aforementioned materials.

A first gate spacer 111 may extend in the second horizontal direction DR2 along both side walls of the first gate electrode G1 on the upper surface of the uppermost nanosheet of the first plurality of nanosheets NW1 and the field insulating layer 105. A second gate spacer 112 may extend in the second horizontal direction DR2 along both side walls of the second gate electrode G2 on the upper surface of the uppermost nanosheet of the second plurality of nanosheets NW2 and the field insulating layer 105. A third gate spacer 113 may extend in the second horizontal direction DR2 along both side walls of the third gate electrode G3 on the upper surface of the uppermost nanosheet of the third plurality of nanosheets NW3 and the field insulating layer 105.

Each of the first to third gate spacers 111, 112 and 113 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof. However, embodiments of the present disclosure are not limited thereto.

A first source/drain region SD1 may be disposed on a first side of the second gate electrode G2 on the upper surface of the active pattern F1. That is, the first source/drain region SD1 may be disposed between the first gate electrode G1 and the second gate electrode G2 on the upper surface of the active pattern F1. A second source/drain region SD2 may be disposed on a second side of the second gate electrode G2 opposite to the first side of the second gate electrode G2 in the first horizontal direction DR1, on the upper surface of the active pattern F1. That is, the second source/drain region SD2 may be disposed between the second gate electrode G2 and the third gate electrode G3 on the upper surface of the active pattern F1. Each source/drain region may act as either a source or a drain, depending on the characteristics of the transistor.

For example, the first source/drain region SD1 may be in contact with the side wall of the first plurality of nanosheets NW1 in the first horizontal direction DR1 and the side wall of the second plurality of nanosheets NW2 in the first horizontal direction DR1. The second source/drain region SD2 may be in contact with the side wall of the second plurality of nanosheets NW2 in the first horizontal direction DR1 and the side wall of the third plurality of nanosheets NW3 in the first horizontal direction DR1. For example, the upper surface of each of the first and second source/drain regions SD1 and SD2 may be formed to be higher in the vertical direction DR3 than the upper surface of the uppermost nanosheet of each of the first to third plurality of nanosheets NW1, NW2, and NW3. For example, at least a part of the first source/drain region SD1 may overlap the active pattern F1 in the vertical direction DR3. Also, at least a part of the second source/drain region SD2 may overlap the active pattern F1 in the vertical direction DR3. For example, each of the first and second source/drain regions SD1 and SD2 is not in contact with the active pattern F1. That is, each of the first and second source/drain regions SD1 and SD2 may be separated from the active pattern F1.

A first gate insulating layer 121 may be disposed between the first gate electrode G1 and the active pattern F1. The first gate insulating layer 121 may be disposed between the first gate electrode G1 and the field insulating layer 105. The first gate insulating layer 121 may be disposed between the first gate electrode G1 and the first gate spacer 111. The first gate insulating layer 121 may be disposed between the first gate electrode G1 and the first plurality of nanosheets NW1. The first gate insulating layer 121 may be disposed between the first gate electrode G1 and the first source/drain region SD1. A second gate insulating layer 122 may be disposed between the second gate electrode G2 and the active pattern F1. The second gate insulating layer 122 may be disposed between the second gate electrode G2 and the field insulating layer 105. The second gate insulating layer 122 may be disposed between the second gate electrode G2 and the second gate spacer 112. The second gate insulating layer 122 may be disposed between the second gate electrode G2 and the second plurality of nanosheets NW2. The second gate insulating layer 122 may be disposed between the second gate electrode G2 and each of the first and second source/drain regions SD1 and SD2.

A third gate insulating layer 123 may be disposed between the third gate electrode G3 and the active pattern F1. The third gate insulating layer 123 may be disposed between the third gate electrode G3 and the field insulating layer 105. The third gate insulating layer 123 may be disposed between the third gate electrode G3 and the third gate spacer 113. The third gate insulating layer 123 may be disposed between the third gate electrode G3 and the third plurality of nanosheets NW3. The third gate insulating layer 123 may be disposed between the third gate electrode G3 and the second source/drain region SD2. For example, each of the first and second gate insulating layers 121 and 122 may be in contact with the first source/drain region SD1. Also, each of the second and third gate insulating layers 122 and 123 may be in contact with the second source/drain region SD2.

Each of the first to third gate insulating layers 121, 122 and 123 may include at least one of silicon oxide, silicon oxynitride, silicon nitride or a high dielectric constant material having a higher dielectric constant than silicon oxide. The high dielectric constant material may include, for example, one or more of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide and/or lead zinc niobate.

The semiconductor device according to some embodiments may include an NC (Negative Capacitance) FET that uses a negative capacitor. For example, each of the first to third gate insulating layers 121, 122 and 123 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitance of the capacitors connected in series is less than the capacitance of each of the individual capacitors. On the other hand, if at least one of the capacitances of two or more capacitors connected in series has a negative value, the overall capacitance of the capacitors connected in series may be greater than an absolute value of each of the individual capacitances, while having a positive value.

When the ferroelectric material film having the negative capacitance and the paraelectric material film having the positive capacitance are connected in series, the overall capacitance value of the ferroelectric material film and the paraelectric material film connected in series may be greater than the absolute value of each of the individual capacitances. By the use of the increased overall capacitance value, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, and/or lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and/or tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and/or yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have the paraelectric properties. The paraelectric material film may include, for example, at least one of silicon oxide and/or a metal oxide having a high dielectric constant. The metal oxide included in the paraelectric material film may include, for example, but not limited to, at least one of hafnium oxide, zirconium oxide, and/or aluminum oxide.

The ferroelectric material film and the paraelectric material film may include the same material. The ferroelectric material film has the ferroelectric properties, but the paraelectric material film may not have the ferroelectric properties. For example, when the ferroelectric material film and the paraelectric material film include hafnium oxide, a crystal structure of hafnium oxide included in the ferroelectric material film is different from a crystal structure of hafnium oxide included in the paraelectric material film.

The ferroelectric material film may have a thickness having the ferroelectric properties. The thickness of the ferroelectric material film may be, for example, but not limited to, 0.5 to 10 nm. Since a critical thickness that exhibits the ferroelectric properties may vary for each ferroelectric material, the thickness of the ferroelectric material film may vary depending on the ferroelectric material.

As an example, each of the first to third gate insulating layers 121, 122 and 123 may include one ferroelectric material film. As another example, each of the first to third gate insulating layers 121, 122 and 123 may include a plurality of ferroelectric material films spaced apart from each other. Each of the first to third gate insulating layers 121, 122 and 123 may have a stacked film structure in which a plurality of ferroelectric material films and a plurality of paraelectric material films are alternately stacked.

The first etch stop layer 140 may be disposed on the side walls of each of the first to third gate spacers 111, 112 and 113 in the first horizontal direction DR1. The first etch stop layer 140 may be disposed on the upper surface of the field insulating layer 105. The first etch stop layer 140 may be disposed on the upper surfaces of each of the first and second source/drain regions SD1 and SD2. The first etch stop layer 140 may be disposed on the side walls of each of the first and second source/drain regions SD1 and SD2 in the second horizontal direction DR2. For example, the first etch stop layer 140 may be formed conformally. The first etch stop layer 140 may include, for example, at least one of aluminum oxide, aluminum nitride, hafnium oxide, zirconium oxide, silicon oxide, silicon nitride, silicon oxynitride, and/or a low dielectric constant material.

The first capping pattern 131 may extend in the second horizontal direction DR2 on each of the first gate spacer 111, the first gate insulating layer 121, and the first gate electrode G1. The second capping pattern 132 may extend in the second horizontal direction DR2 on each of the second gate spacer 112, the second gate insulating layer 122, and the second gate electrode G2. The third capping pattern 133 may extend in the second horizontal direction DR2 on each of the third gate spacer 113, the third gate insulating layer 123, and the third gate electrode G3.

For example, the lower surface of each of the first to third capping patterns 131, 132 and 133 may be in contact with the first etch stop layer 140. However, embodiments of the present disclosure are not limited thereto. In some other embodiments, the side wall of each of the first to third capping patterns 131, 132 and 133 may be in contact with the first etch stop layer 140. Each of the first to third capping patterns 131, 132 and 133 may include, for example, at least one of silicon nitride (SiN), silicon oxynitride (SiON), silicon oxide (SiO₂), silicon carbonitride (SiCN), silicon oxycarbonitride (SiOCN), and combinations thereof. However, embodiments of the present disclosure are not limited thereto.

The first upper interlayer insulating layer 150 may be disposed on the first etch stop layer 140. The first upper interlayer insulating layer 150 may be disposed on the side walls of each of the first to third capping patterns 131, 132 and 133. The first upper interlayer insulating layer 150 may be on and at least partially cover each of the first and second source/drain regions SD1 and SD2 on the field insulating layer 105. For example, the upper surface of the first upper interlayer insulating layer 150 may be formed on the same plane as the upper surfaces of each of the first to third capping patterns 131, 132 and 133. The first upper interlayer insulating layer 150 may include, for example, at least one of silicon oxide, silicon nitride, silicon oxynitride, and/or a low dielectric constant material.

The gate contact CB may be disposed above the second gate electrode G2 in the vertical direction DR3. The gate contact CB penetrates or extends through the second capping pattern 132 in the vertical direction DR3, and may be connected to the second gate electrode G2. Although the gate contact CB is shown as being formed of a single film in FIG. 3, embodiments of the present disclosure are not limited thereto. In some other embodiments, the gate contact CB may be formed of multiple films. For example, the upper surface of the gate contact CB may be formed on the same plane as the upper surface of the first upper interlayer insulating layer 150, but embodiments of the present disclosure are not limited thereto. The gate contact CB may include a conductive material.

The upper source/drain contact UCA may be disposed between the first gate electrode G1 and the second gate electrode G2. The upper source/drain contact UCA may be disposed above the first source/drain region SD1 in the vertical direction DR3. The upper source/drain contact UCA may penetrate or extend through the first upper interlayer insulating layer 150 and the first etch stop layer 140 in the vertical direction DR3 and extend into the first source/drain region SD1. The upper source/drain contact UCA may be electrically connected to the first source/drain region SD1. Although the upper source/drain contact UCA is shown as being formed of a single film in FIG. 2, embodiments of the present disclosure are not limited thereto. In some other embodiments, the upper source/drain contact UCA may be formed of a multiple film.

For example, the upper surface of the upper source/drain contact UCA may be formed on the same plane as the upper surface of the first upper interlayer insulating layer 150. However, embodiments of the present disclosure are not limited thereto. In some other embodiments, the upper surface of the upper source/drain contact UCA may be formed to be higher in the vertical direction DR3 than the upper surface of the first upper interlayer insulating layer 150. The upper source/drain contact UCA may include a conductive material.

The upper silicide layer USL may be disposed between the upper source/drain contact UCA and the first source/drain region SD1. The upper silicide layer USL may be disposed along an interface between the upper source/drain contact UCA and the first source/drain region SD1. The upper silicide layer USL may include, for example, a metal silicide material.

The lower source/drain contact BCA may be disposed below the second source/drain region SD2 in the vertical direction DR3. The lower source/drain contact BCA penetrates or extends through the lower interlayer insulating layer 100, the insulating pattern 101, and the active pattern F1 in the vertical direction DR3, and may be electrically connected to the second source/drain region SD2. For example, at least a part of the lower source/drain contact BCA may extend into the second source/drain region SD2. For example, the upper surface of the lower source/drain contact BCA may be formed to be higher than each of the upper surface of the active pattern F1 and the upper surface of the field insulating layer 105 in the vertical direction DR3.

For example, the side wall of the lower source/drain contact BCA may be surrounded by each of the lower interlayer insulating layer 100, the insulating pattern 101, the active pattern F1, and the field insulating layer 105 in a plan view of the semiconductor device. For example, the lower source/drain contact BCA may be spaced apart from each of the lower interlayer insulating layer 100, the insulating pattern 101, the active pattern F1, and the field insulating layer 105. That is, the side walls of the lower source/drain contact BCA are not in contact with each of the lower interlayer insulating layer 100, the insulating pattern 101, the active pattern F1, and the field insulating layer 105. For example, the lower source/drain contact BCA may be formed of a single film. However, embodiments of the present disclosure are not limited thereto. In some other embodiments, the lower source/drain contact BCA may be formed of a multiple film. The lower source/drain contact BCA may include a conductive material.

The insulating liner layer 160 may surround the side walls of the lower source/drain contact BCA on the lower surface of the second source/drain region SD2 in a plan view of the semiconductor device. For example, both side walls of the insulating liner layer 160 in the first horizontal direction DR1 may be disposed between each of the lower interlayer insulating layer 100, the insulating pattern 101, and the active pattern F1, and the lower source/drain contact BCA. Also, both side walls of the insulating liner layer 160 in the first horizontal direction DR1 may be disposed between a second buried insulating pattern 103 to be described below and the lower source/drain contact BCA. For example, both side walls of the insulating liner layer 160 in the second horizontal direction DR2 may be disposed between each of the lower interlayer insulating layer 100 and the field insulating layer 105 and the lower source/drain contact BCA.

For example, the insulating liner layer 160 may be in contact with both side walls of the lower source/drain contact BCA in the first horizontal direction DR1. Also, the insulating liner layer 160 may be in contact with both side walls of the lower source/drain contact BCA in the second horizontal direction DR2. For example, the insulating liner layer 160 may be in contact with each of the lower interlayer insulating layer 100, the insulating pattern 101, the active pattern F1, and the field insulating layer 105. For example, the insulating liner layer 160 may be formed conformally. The insulating liner layer 160 may include an insulating material. For example, the insulating liner layer 160 may include a material different from each of the lower interlayer insulating layer 100, the insulating pattern 101, the active pattern F1, and the field insulating layer 105. Further, for example, the insulating liner layer 160 may include a different material from each of first and second buried insulating patterns 102 to 103 to be described below. For example, the insulating liner layer 160 may include, for example, at least one of silicon nitride (SiN), silicon oxynitride (SiON), silicon oxycarbide (SiOC), silicon carbonitride (SiCN) and/or silicon oxycarbonitride (SiOCN). However, embodiments of the present disclosure is not limited thereto.

A first buried insulating pattern 102 may be disposed below the first source/drain region SD1 in the vertical direction DR3. For example, the first buried insulating pattern 102 may protrude in the vertical direction DR3 from an upper surface of the insulating pattern 101. For example, a lower surface of the first buried insulating pattern 102 may be in contact with the upper surface of the insulating pattern 101. For example, both side walls of the first buried insulating pattern 102 in the first horizontal direction DR1 may be in contact with the active pattern F1. Although not shown, for example, both side walls of the first buried insulating pattern 102 in the second horizontal direction DR2 may be in contact with the field insulating layer 105. For example, the upper surface of the first buried insulating pattern 102 may be in contact with the lower surface of the first source/drain region SD1.

For example, a width of the upper part of the first buried insulating pattern 102 in the first horizontal direction DR1 may be greater than a width of the lower part of the first buried insulating pattern 102 in the first horizontal direction DR1. For example, the upper part of the first buried insulating pattern 102 may protrude beyond the lower part of the first buried insulating pattern 102 in the first horizontal direction DR1. For example, at least a part of the first buried insulating pattern 102 may overlap the active pattern F1 in the vertical direction DR3. That is, the upper part of the first buried insulating pattern 102 that protrudes beyond the lower part of the first buried insulating pattern 102 in the first horizontal direction DR1 may overlap the active pattern F1 in the vertical direction DR3. For example, the first buried insulating pattern 102 does not overlap each of the first and second gate electrodes G1 and G2 in the vertical direction DR3. For example, the first buried insulating pattern 102 does not overlap each of the first and second plurality of nanosheets NW1 and NW2 in the vertical direction DR3.

The second buried insulating pattern 103 may be disposed below the second source/drain region SD2 in the vertical direction DR3. For example, the second buried insulating pattern 103 may be disposed on both side walls of the lower source/drain contact BCA in the first horizontal direction DR1. For example, the second buried insulating pattern 103 may be disposed on both side walls of the insulating liner layer 160 in the first horizontal direction DR1. For example, the inner side walls of the second buried insulating pattern 103 may be in contact with both side walls of the insulating liner layer 160 in the first horizontal direction DR1. For example, the lower surface of the second buried insulating pattern 103 and both side walls in the first horizontal direction DR1 of the second buried insulating pattern 103 may be in contact with the active pattern F1. For example, the upper surface of the second buried insulating pattern 103 may be in contact with the lower surface of the second source/drain region SD2.

For example, the upper surface of the second buried insulating pattern 103 may be formed on the same plane as the upper surface of the insulating liner layer 160. For example, the second buried insulating pattern 103 may overlap the active pattern F1 in the vertical direction DR3. For example, the second buried insulating pattern 103 does not overlap each of the second and third gate electrodes G2 and G3 in the vertical direction DR3. For example, the second buried insulating pattern 103 does not overlap each of the second and third nanosheets NW2 and NW3 in the vertical direction DR3.

For example, the first buried insulating pattern 102 may separate the active pattern F1 from the first source/drain region SD1. Also, the second buried insulating pattern 103 may separate the active pattern F1 from the second source/drain region SD2. For example, the upper surface of the first buried insulating pattern 102 and the upper surface of the second buried insulating pattern 103 may be formed on the same plane as the upper surface of the active pattern F1, but the present disclosure is not limited thereto. For example, the first buried insulating pattern 102 and the second buried insulating pattern 103 may include the same material. Each of the first and second buried insulating patterns 102 and 103 may include an insulating material. For example, each of the first and second buried insulating patterns 102 and 103 may include the same material as each of the lower interlayer insulating layer 100 and the insulating pattern 101.

The lower silicide layer BSL may be disposed between the lower source/drain contact BCA and the second source/drain region SD2. The lower silicide layer BSL may be disposed along an interface between the lower source/drain contact BCA and the second source/drain region SD2. For example, the lower silicide layer BSL may be in contact with the upper surface of the insulating liner layer 160. The upper silicide layer USL may include, for example, a metal silicide material.

The second etch stop layer 170 may be disposed on the upper surfaces of each of the upper source/drain contact UCA, the first to third capping patterns 131, 132 and 133, and the first upper interlayer insulating layer 150. Although the second etch stop layer 170 is shown to be formed of a single film in FIGS. 2 to 4, embodiments of the present disclosure are not limited thereto. In some other embodiments, the second etch stop layer 170 may be formed of multiple films. The second etch stop layer 170 may include, for example, at least one of aluminum oxide, aluminum nitride, hafnium oxide, zirconium oxide, silicon oxide, silicon nitride, silicon oxynitride, and/or a low dielectric constant material. The second upper interlayer insulating layer 180 may be disposed on the second etch stop layer 170. The second upper interlayer insulating layer 180 may include, for example, at least one of silicon oxide, silicon nitride, silicon oxynitride, and/or a low dielectric constant material.

A first via V1 penetrates or extends through the second upper interlayer insulating layer 180 and the second etch stop layer 170 in the vertical direction DR3, and may be connected to the upper source/drain contact UCA. A second via V2 penetrates or extends through the second upper interlayer insulating layer 180 and the second etch stop layer 170 in the vertical direction DR3, and may be connected to the gate contact CB. Although the first via V1 and the second via V2 are shown to be formed of a single film in FIGS. 2 and 3, embodiments of the present disclosure are not limited thereto. In some other embodiments, each of the first via V1 and the second via V2 may be formed of multiple films. Each of the first via V1 and the second via V2 may include a conductive material.

In the semiconductor device according to some embodiments of the present disclosure, the second buried insulating pattern 103 and the insulating liner layer 160 may be disposed between the second source/drain region SD2, to which the lower source/drain contact BCA is electrically connected, and the active pattern F1. In the semiconductor device according to some embodiments of the present disclosure, the second source/drain region SD2 may be electrically insulated from the active pattern F1, by using the second buried insulating pattern 103 and the insulating liner layer 160. Therefore, the semiconductor device according to some embodiments of the present disclosure may improve the reliability of the second source/drain region SD2 electrically connected to the lower source/drain contact BCA.

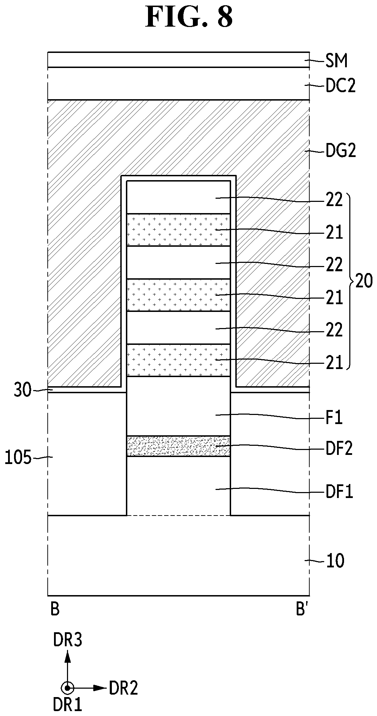

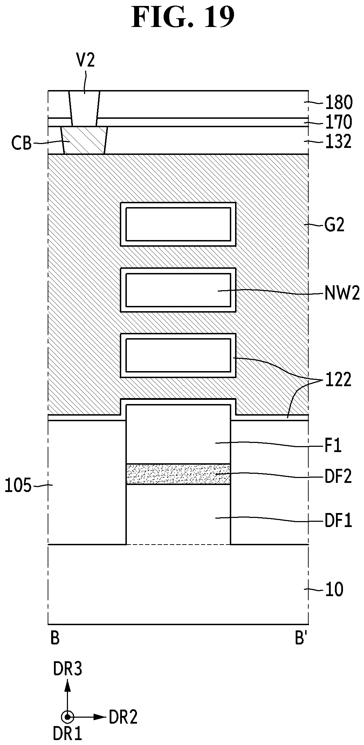

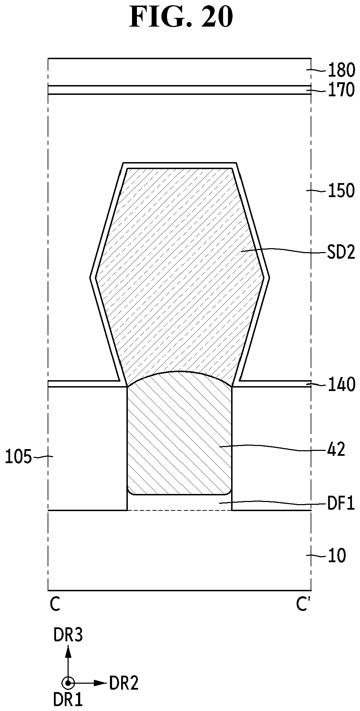

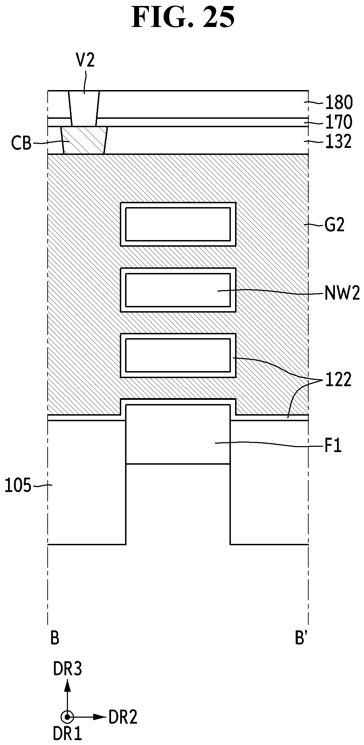

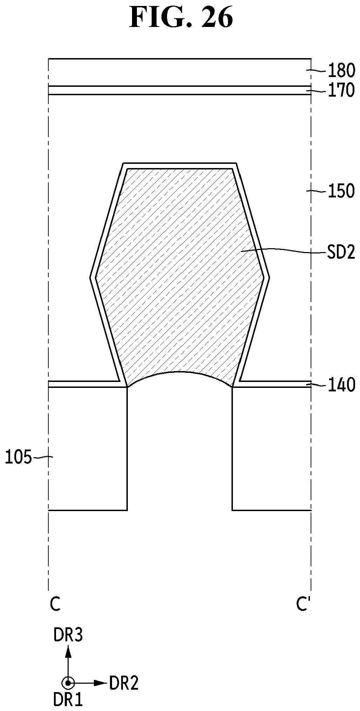

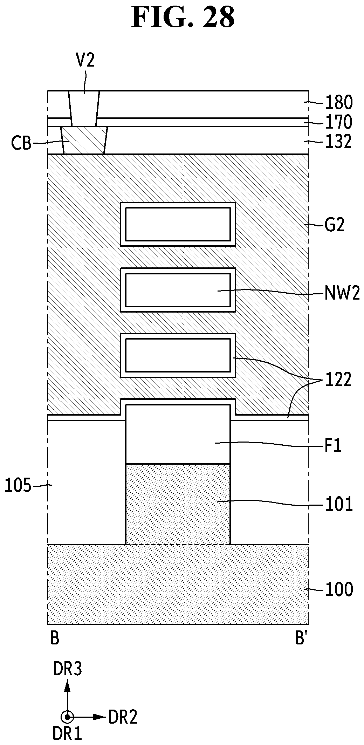

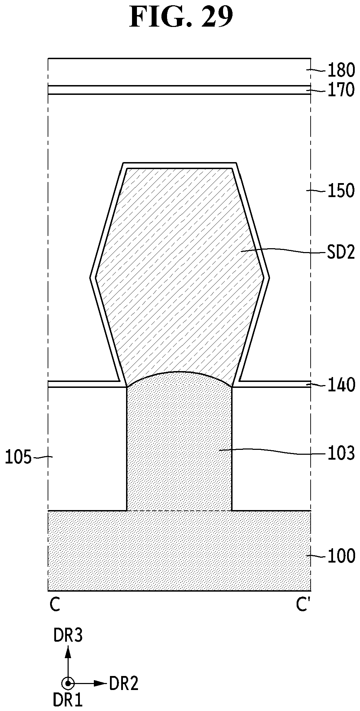

Hereinafter, a method for fabricating a semiconductor device according to some embodiments of the present disclosure will be described with reference to FIGS. 2 to 35.

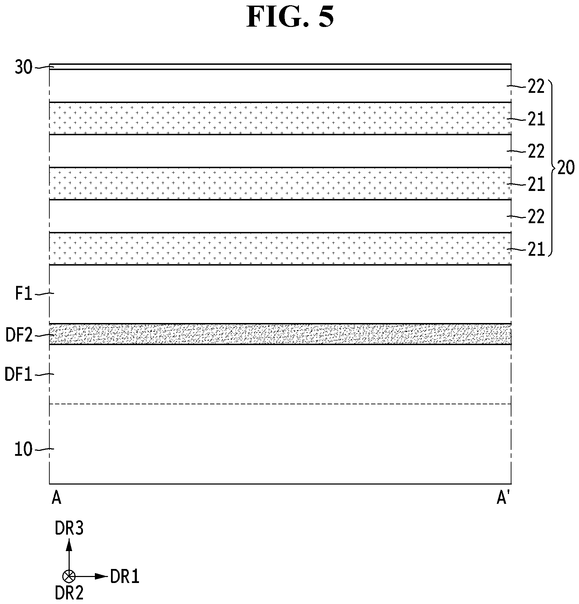

FIGS. 5 to 35 are intermediate stage diagrams illustrating the method for fabricating the semiconductor device according to some embodiments of the present disclosure.

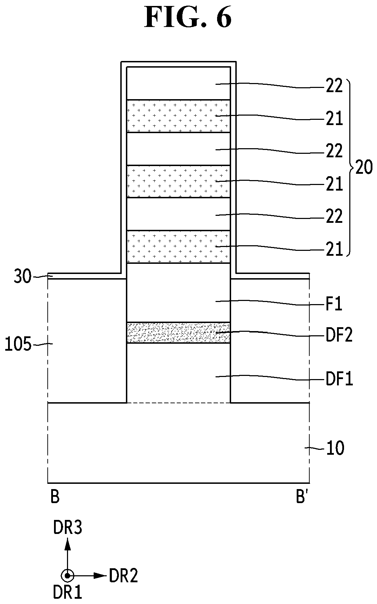

Referring to FIGS. 5 and 6, a substrate 10 may be provided. The substrate 10 may be a silicon substrate or a silicon-on-insulator (SOI). In other embodiments, the substrate 10 may include silicon germanium, silicon germanium on insulator (SGOI), indium antimonide, lead telluride, indium arsenide, indium phosphide, gallium arsenide or gallium antimonide, but embodiments of the present disclosure are not limited thereto.

A first dummy active pattern DF1, a second dummy active pattern DF2, an active pattern F1, and a stacked structure 20 may be formed on the upper surface of the substrate 10. For example, the first dummy active pattern DF1 may protrude from the upper surface of the substrate 10 in the vertical direction DR3. The first dummy active pattern DF1 may include the same material as the substrate 10. For example, the first dummy active pattern DF1 may include silicon (Si). The second dummy active pattern DF2 may be formed on the upper surface of the first dummy active pattern DF1. For example, both side walls of the second dummy active pattern DF2 in the second horizontal direction DR2 may be aligned with both side walls of the first dummy active pattern DF1 in the second horizontal direction DR2. For example, the second dummy active pattern DF2 may include silicon germanium (SiGe). The active pattern F1 may be formed on the upper surface of the second dummy active pattern DF2. For example, both side walls of the active pattern F1 in the second horizontal direction DR2 may be aligned with both side walls of the second dummy active pattern DF2 in the second horizontal direction DR2. For example, the active pattern F1 may include silicon (Si).

The stacked structure 20 may be formed on the upper surface of the active pattern F1. For example, both side walls of the stacked structure 20 in the second horizontal direction DR2 may be aligned with both side walls of the active pattern F1 in the second horizontal direction DR2. Each of the first dummy active pattern DF1, the second dummy active pattern DF2, the active pattern F1, and the stacked structure 20 may extend in the first horizontal direction DR1. The stacked structure 20 may include a first semiconductor layer 21 and a second semiconductor layer 22 that are alternately stacked on the upper surface of the active pattern F1. For example, the first semiconductor layer 21 may be formed at the lowermost part of the stacked structure 20, and the second semiconductor layer 22 may be formed at the uppermost part of the stacked structure 20. However, embodiments of the present disclosure are not limited thereto. In some other embodiments, the first semiconductor layer 21 may also be formed at the uppermost part of the stacked structure 20. The first semiconductor layer 21 may include, for example, silicon germanium (SiGe). The second semiconductor layer 22 may include, for example, silicon (Si).

Subsequently, the field insulating layer 105 may be formed on the upper surface of the substrate 10. The field insulating layer 105 may surround side walls of each of the first dummy active pattern DF1, the second dummy active pattern DF2, and the active pattern F1 in a plan view of the semiconductor device. For example, the upper surface of the second dummy active pattern DF2 may be formed to be lower than the upper surface of the field insulating layer 105 in the vertical direction DR3. For example, the upper surface of the active pattern F1 may be formed to be higher than the upper surface of the field insulating layer 105 in the vertical direction DR3. Next, a pad oxide layer 30 may be formed to be on and at least partially cover the upper surface of the field insulating layer 105, the side walls of each of the exposed active patterns F1, and the side walls and upper surface of the stacked structure 20. For example, the pad oxide layer 30 may be formed conformally. The pad oxide layer 30 may include, for example, silicon oxide (SiO₂).

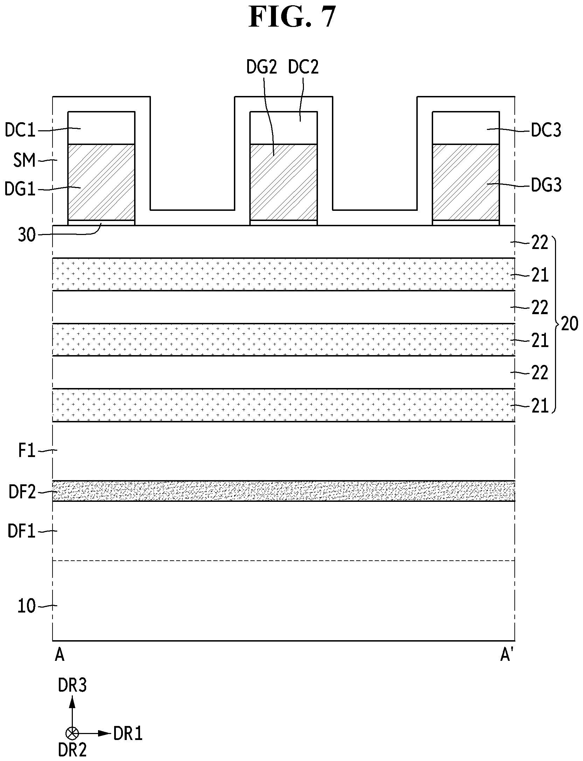

Referring to FIGS. 7 to 9, first to third dummy gates DG1, DG2 and DG3 and first to third dummy capping patterns DC1, DC2 and DC3 extending in the second horizontal direction DR2 on the pad oxide layer 30 may be formed on the stacked structure 20 and the field insulating layer 105. Specifically, the second dummy gate DG2 may be spaced apart from the first dummy gate DG1 in the first horizontal direction DR1. The third dummy gate DG3 may be spaced apart from the second dummy gate DG2 in the first horizontal direction DR1. The first dummy capping pattern DC1 may be formed on the first dummy gate DG1. The second dummy capping pattern DC2 may be formed on the second dummy gate DG2. The third dummy capping pattern DC3 may be formed on the third dummy gate DG3. While the first to third dummy gates DG1, DG2 and DG3 and the first to third dummy capping patterns DC1, DC2 and DC3 are formed, the remaining pad oxide layer 30 except for the portions that overlap the first to third dummy gates DG1, DG2 and DG3 in the vertical direction DR3 on the substrate 10 may be removed.

Next, a spacer material layer SM may be formed to be on and at least partially cover the side walls of each of the first to third dummy gates DG1, DG2 and DG3, the side walls and upper surfaces of each of the first to third dummy capping patterns DC1, DC2 and DC3, the side wall and upper surface of the exposed stacked structure 20, and the upper surface of the field insulating layer 105. For example, the spacer material layer SM may be formed conformally. The spacer material layer SM may include at least one of, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof.

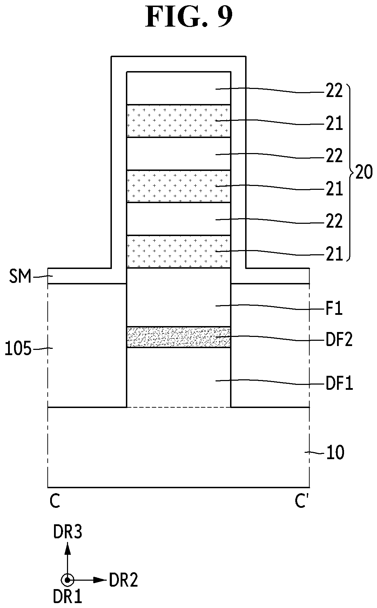

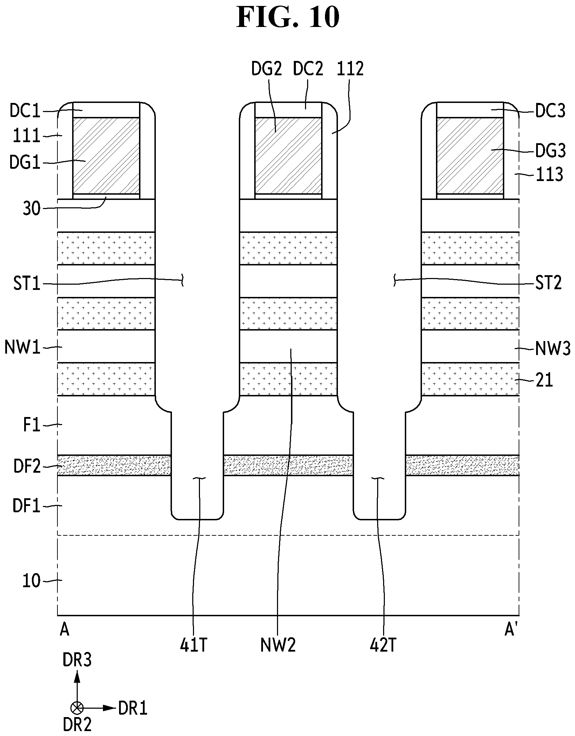

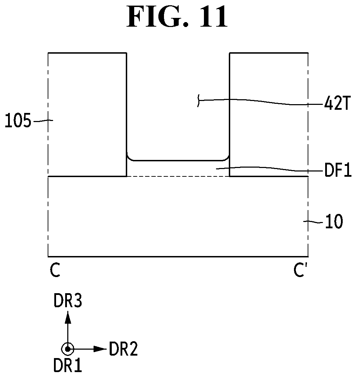

Referring to FIGS. 10 and 11, the stacked structure (20 of FIG. 7 and FIG. 9) may be etched, by using the first to third dummy gates DG1, DG2 and DG3 and the first to third dummy capping patterns DC1, DC2 and DC3 as a mask, thereby forming first and second source/drain trenches ST1 and ST2. The first source/drain trench ST1 may be formed between the first dummy gate DG1 and the second dummy gate DG2. The second source/drain trench ST2 may be formed between the second dummy gate DG2 and the third dummy gate DG3. For example, the lower surfaces of each of the first and second source/drain trenches ST1 and ST2 may be formed to be lower than the upper surface of the active pattern F1 in the vertical direction DR3. That is, each of the first and second source/drain trenches ST1 and ST2 may extend into the active pattern F1. The bottom surface of each of the first and second source/drain trenches ST1 and ST2 may be above the second dummy active pattern DF2.

Next, a first sacrificial pattern trench 41T may be formed below the first source/drain trench ST1, and a second sacrificial pattern trench 42T may be formed below the second source/drain trench ST2 in the vertical direction DR3. For example, each of the first and second sacrificial pattern trenches 41T and 42T may penetrate or extend through each of the active pattern F1 and the second dummy active pattern DF2 in the vertical direction DR3 and extend into the first dummy active pattern DF1. For example, the bottom surfaces of each of the first and second sacrificial pattern trenches 41T and 42T may be defined by the first dummy active pattern DF1. For example, a width of the first sacrificial pattern trench 41T in the first horizontal direction DR1 may be less than a width of the first source/drain trench ST1 in the first horizontal direction DR1. Also, a width of the second sacrificial pattern trench 42T in the first horizontal direction DR1 may be less than the width of the second source/drain trench ST2 in the first horizontal direction DR1. For example, the side wall of the field insulating layer 105 in the second horizontal direction DR2 may be exposed through the second sacrificial pattern trench 42T.

For example, while the first and second source/drain trenches ST1 and ST2 and the first and second sacrificial pattern trenches 41T and 42T are being formed, the spacer material layer (SM of FIGS. 7 to 9) formed on the upper surfaces of each of the first to third dummy capping patterns DC1, DC2 and DC3 and a part of each of the first to third dummy capping patterns DC1, DC2 and DC3 may be removed. The spacer material layer (SM of FIG. 7) that remains on the side walls of each of the first to third dummy capping patterns DC1, DC2 and DC3 and the first to third dummy gates DG1, DG2 and DG3 may be defined as first to third gate spacers 111, 112 and 113.

For example, after the first and second source/drain trenches ST1 and ST2 and the first and second sacrificial pattern trenches 41T and 42T are formed, the second semiconductor layer (22 of FIG. 7) that remains below the first dummy gate DG1 on the active pattern F1 may be defined as the first plurality of nanosheets NW1, the second semiconductor layer (22 of FIG. 7) that remains below the second dummy gate DG2 on the active pattern F1 may be defined as the second plurality of nanosheets NW2, and the second semiconductor layer (22 of FIG. 7) that remains below the third dummy gate DG3 on the active pattern F1 may be defined as the second plurality of nanosheets NW3.

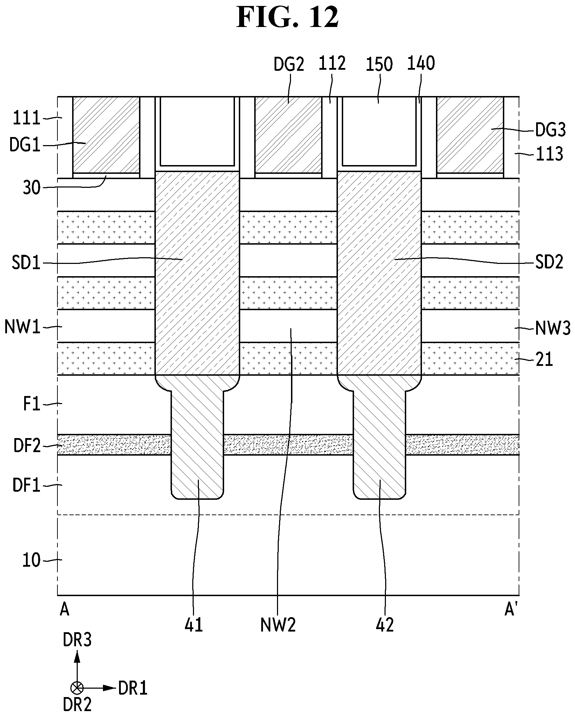

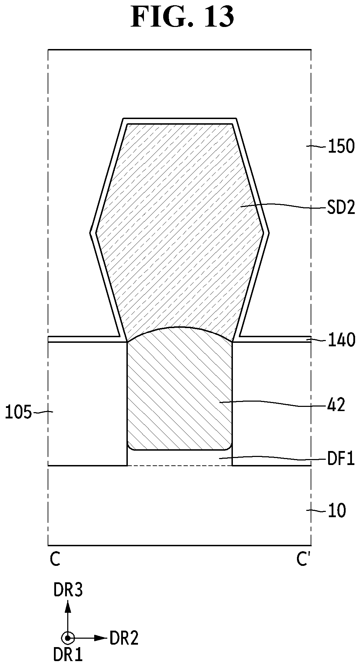

Referring to FIGS. 12 and 13, a first sacrificial pattern 41 may be formed inside the first sacrificial pattern trench 41T, and a second sacrificial pattern 42 may be formed inside the second sacrificial pattern trench 42T. For example, the upper surfaces of each of the first and second sacrificial patterns 41 and 42 may be formed on the same plane as the upper surface of the active pattern F1. For example, the upper surface of the second sacrificial pattern 42 may be formed to be higher than the upper surface of the field insulating layer 105 in the vertical direction DR3. Although not shown, for example, the upper surface of the first sacrificial pattern 41 may be formed to be higher than the upper surface of the field insulating layer 105 in the vertical direction DR3. For example, each of the first and second sacrificial patterns 41 and 42 may include silicon germanium (SiGe). For example, the concentration of germanium (Ge) contained in each of the first and second sacrificial patterns 41 and 42 may be higher than the concentration of germanium (Ge) contained in the first semiconductor layer 21.

Then, a first source/drain region SD1 may be formed inside the first source/drain trench ST1, and a second source/drain region SD2 may be formed inside the second source/drain trench ST2. For example, the lower surface of the first source/drain region SD1 may be in contact with the upper surface of the first sacrificial pattern 41. In addition, the lower surface of the second source/drain region SD2 may be in contact with the upper surface of the second sacrificial pattern 42.

Next, the first etch stop layer 140 may be formed on the exposed upper surface of the field insulating layer 105, the exposed side walls of each of the first to third gate spacers 111, 112 and 113, the exposed upper surfaces of each of the first to third dummy capping patterns (DC1, DC2 and DC3 of FIG. 10), and the exposed surfaces of each of the first and second source/drain regions SD1 and SD2. For example, the first etch stop layer 140 may be formed conformally. Next, the first upper interlayer insulating layer 150 may be formed on the first etch stop layer 140. Next, the upper surfaces of each of the first to third dummy gates DG1, DG2 and DG3 may be exposed through a planarization process.

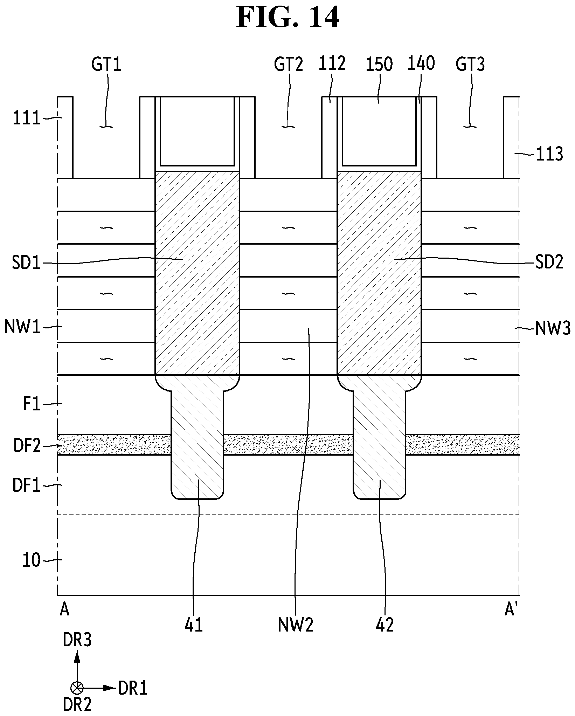

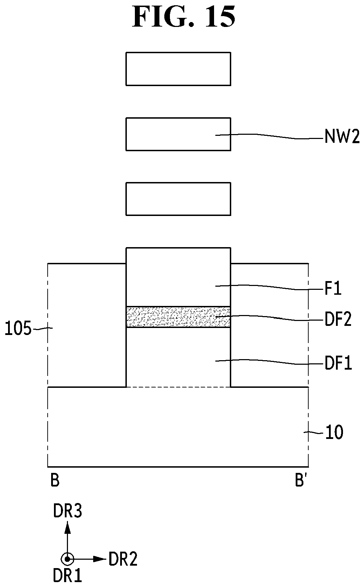

Referring to FIGS. 14 and 15, each of the first to third dummy gates (DG1, DG2, DG3 of FIG. 12), the pad oxide layer (30 of FIG. 12), and the first semiconductor layer (21 of FIG. 12) may be etched. The portion at which the first dummy gate (DG1 of FIG. 12), the pad oxide layer (30 of FIG. 12), and the first semiconductor layer (21 of FIG. 12) are etched may be defined as a first gate trench GT1. The portion at which the second dummy gate (DG2 of FIG. 12), the pad oxide layer (30 of FIG. 12), and the first semiconductor layer (21 of FIG. 12) are etched may be defined as a second gate trench GT2. The portion at which the third dummy gate (DG3 of FIG. 12), the pad oxide layer (30 of FIG. 12), and the first semiconductor layer (21 of FIG. 12) are etched may be defined as a third gate trench GT3.

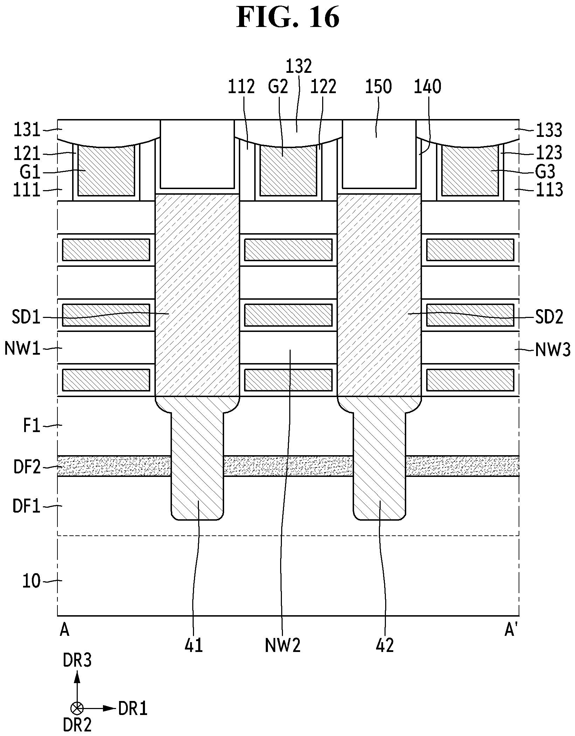

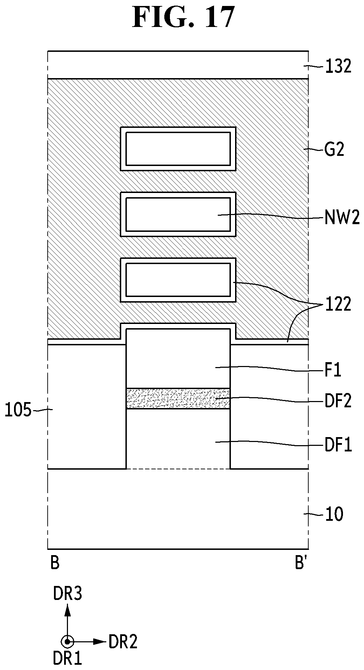

Referring to FIGS. 16 and 17, the first gate insulating layer 121, the first gate electrode G1, and the first capping pattern 131 may be sequentially formed inside the first gate trench (GT1 of FIG. 14). Also, the second gate insulating layer 122, the second gate electrode G2, and the second capping pattern 132 may be sequentially formed inside the second gate trench (GT2 of FIG. 14). Also, the third gate insulating layer 123, the third gate electrode G3, and the third capping pattern 133 may be sequentially formed inside the third gate trench (GT3 of FIG. 14).

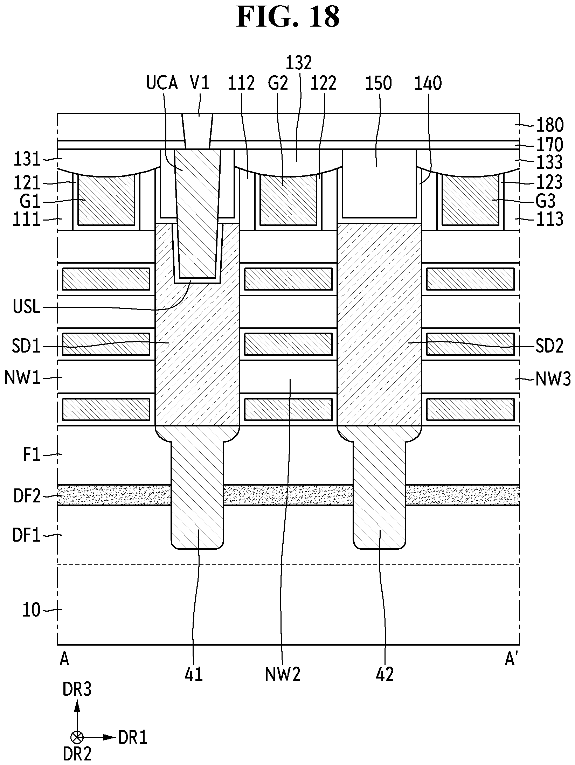

Referring to FIGS. 18 to 20, the upper source/drain contact UCA may be formed above the first source/drain region SD1 in the vertical direction DR3. The upper source/drain contact UCA may penetrate or extend through the first upper interlayer insulating layer 150 and the first etch stop layer 140 in the vertical direction DR3, and extend into the first source/drain region SD1. Also, an upper silicide layer USL may be formed between the first source/drain region SD1 and the upper source/drain contact UCA. Also, a gate contact CB that penetrates or extends through the second capping pattern 132 in the vertical direction DR3 and is connected to the second gate electrode G2 may be formed.

Next, a second etch stop layer 170 and a second upper interlayer insulating layer 180 may be sequentially formed on the upper surfaces of each of the first upper interlayer insulating layer 150, the first to third capping patterns 131, 132 and 133, and the upper source/drain contact UCA. Next, the first via V1 that penetrates or extends through the second etch stop layer 170 and the second upper interlayer insulating layer 180 in the vertical direction DR3 and is connected to the upper source/drain contact UCA may be formed. Also, the second via V2 which penetrates or extends through the second etch stop layer 170 and the second upper interlayer insulating layer 180 in the vertical direction DR3 and is connected to the gate contact CB may be formed.

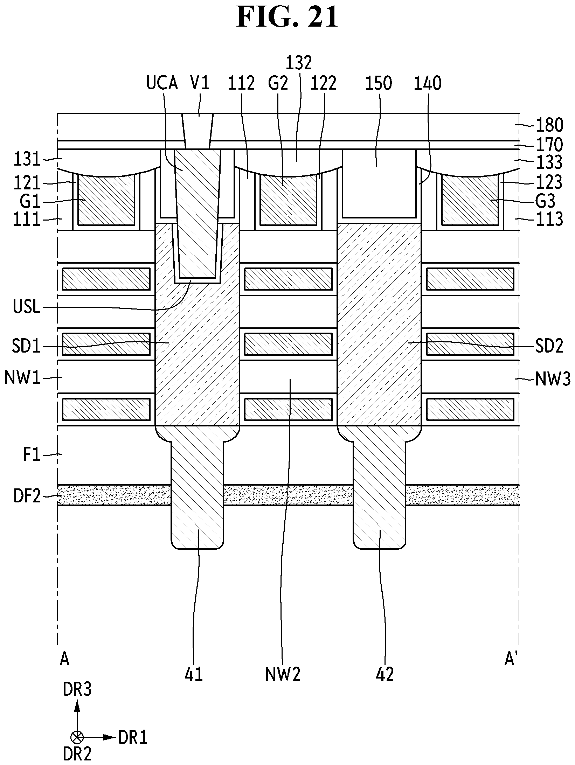

Referring to FIGS. 21 to 23, each of the substrate (10 of FIGS. 18 to 20) and the first dummy active pattern (DF1 of FIGS. 18 to 20) may be etched. Accordingly, the lower surface of the second dummy active pattern DF2, a part of each of the first and second sacrificial patterns 41 and 42, and a part of the field insulating layer 105 may be exposed.

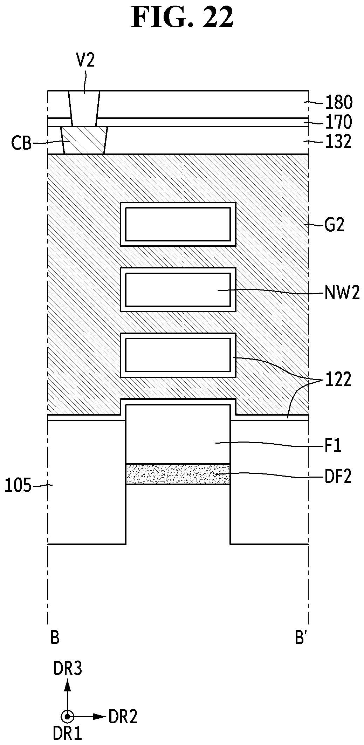

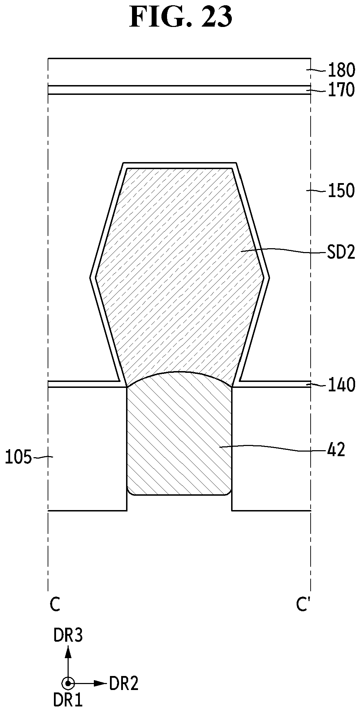

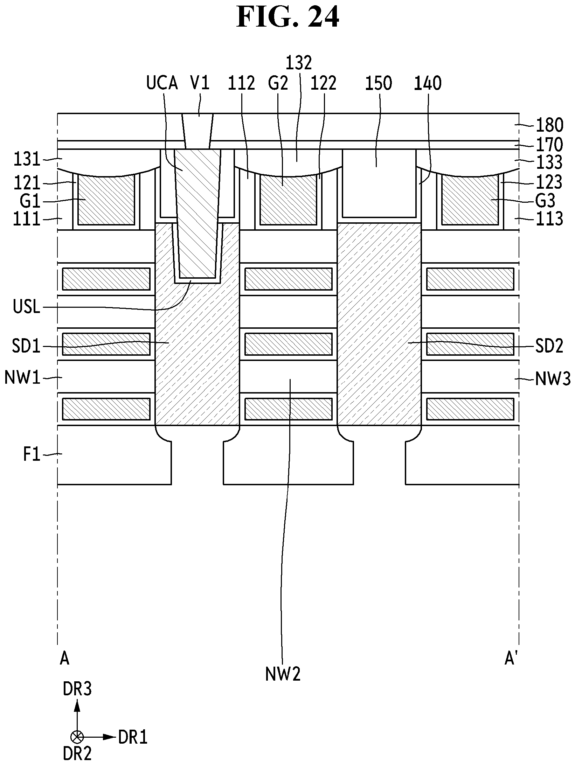

Referring to FIGS. 24 to 26, each of the second dummy active pattern (DF2 of FIGS. 21 and 22), the first sacrificial pattern (41 of FIG. 21), and the second sacrificial pattern (42 of FIG. 21 and 23) may be etched. Accordingly, each of the lower surface of the active pattern F1, the lower surface of the first source/drain region SD1, and the lower surface of the second source/drain region SD2 may be exposed.

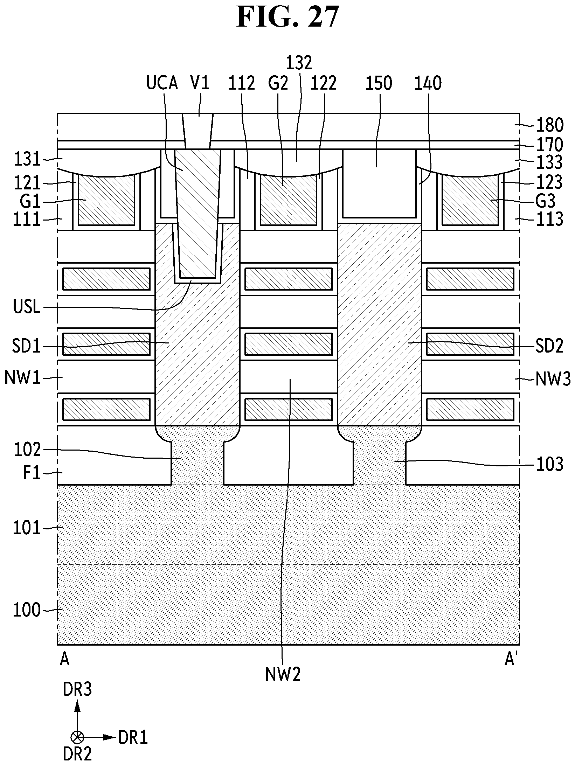

Referring to FIGS. 27 to 29, the first buried insulating pattern 102, the second buried insulating pattern 103, and the insulating pattern 101 may be formed at the portion in which each of the first dummy active pattern (DF1 of FIGS. 18 to 20), the second dummy active pattern (DF2 of FIGS. 21 and 22), the first sacrificial pattern (41 of FIG. 21), and the second sacrificial pattern (42 of FIGS. 21 and 23) are etched. Also, the lower interlayer insulating layer 100 may be formed at the etched portion of the substrate (10 of FIGS. 18 to 20). For example, each of the first buried insulating pattern 102, the second buried insulating pattern 103, the insulating pattern 101, and the lower interlayer insulating layer 100 may be formed through the same fabricating process. For example, each of the first buried insulating pattern 102, the second buried insulating pattern 103, the insulating pattern 101, and the lower interlayer insulating layer 100 may include the same material.

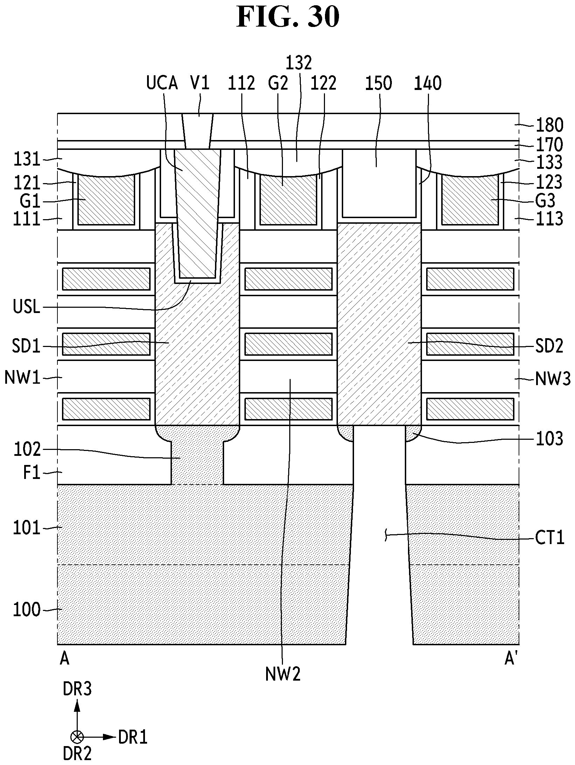

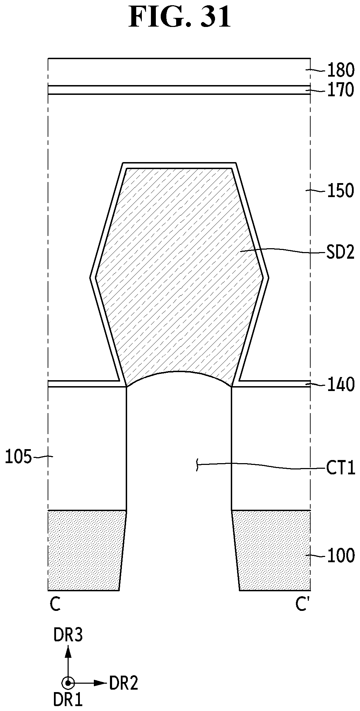

Referring to FIGS. 30 and 31, a first contact trench CT1 may be formed below the second source/drain region SD2 in the vertical direction DR3. For example, the first contact trench CT1 may penetrate or extend through the lower interlayer insulating layer 100, the insulating pattern 101, and the second buried insulating pattern 103 in the vertical direction DR3 to expose the lower surface of the second source/drain region SD2. For example, each of the active pattern F1, the second buried insulating pattern 103, and the field insulating layer 105 may be exposed through the first contact trench CT1.

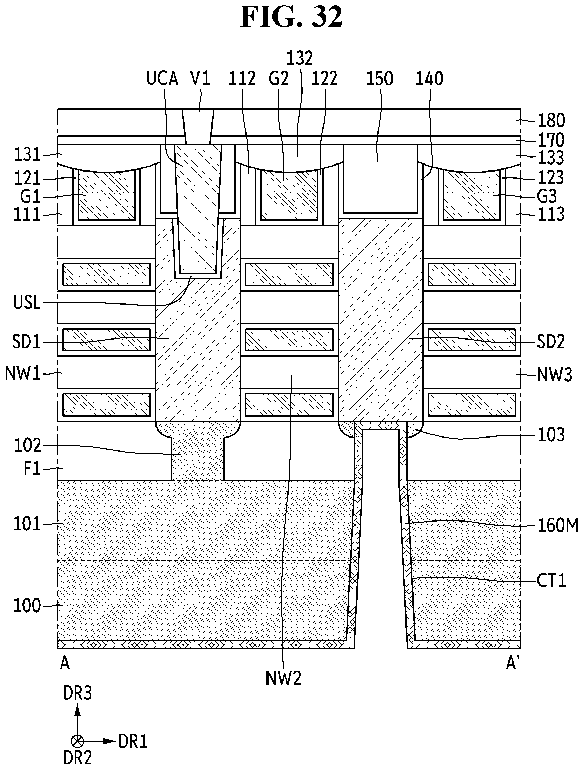

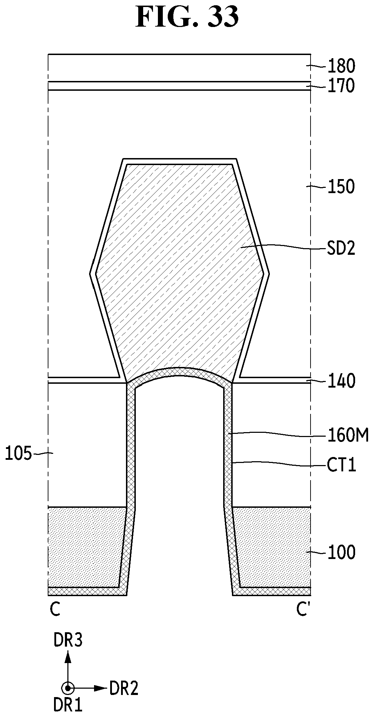

Referring to FIGS. 32 and 33, an insulating liner material layer 160M may be formed along the side wall and upper surface of the first contact trench CT1. For example, the insulating liner material layer 160M may also be formed on the lower surface of the lower interlayer insulating layer 100. For example, the insulating liner material layer 160M may be formed conformally. For example, the insulating liner material layer 160M may include an insulating material. For example, the insulating liner material layer 160M may include a material different from each of the lower interlayer insulating layer 100, the insulating pattern 101, the active pattern F1, the second buried insulating pattern 103, and the field insulating layer 105. For example, although the insulating liner material layer 160M may include silicon nitride (SiN), silicon oxynitride (SiON), silicon oxycarbide (SiOC), silicon carbonitride (SiCN) or silicon oxycarbonitride (SiOCN), embodiments of the present disclosure are not limited thereto.

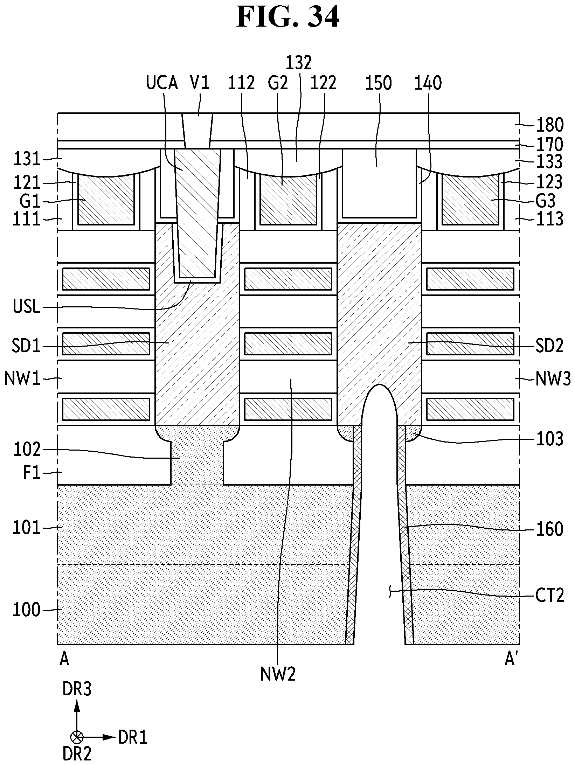

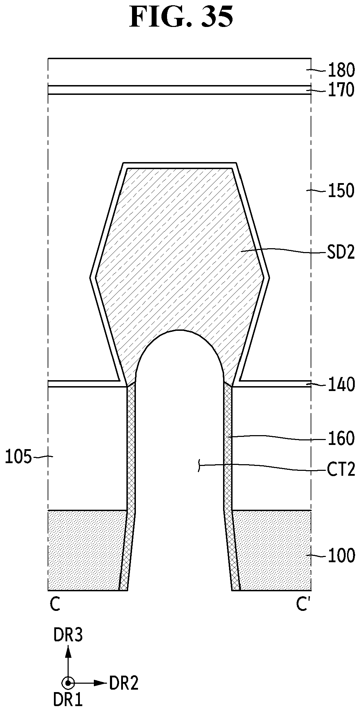

Referring to FIGS. 34 and 35, an etch-back etching process may be performed to etch the insulating liner material layer (160M of FIG. 32 and FIG. 33) formed on the upper surface of the first contact trench (CT1 of FIG. 32 and FIG. 33) and the lower surface of the lower interlayer insulating layer 100. For example, a part of the second source/drain region SD2 may also be etched, while the etch-back etching process is being performed. After the etch-back etching process is completed, the remaining insulating liner material layer (160M of FIGS. 32 and 33) may be defined as the insulating liner layer 160. After the etch-back etching process is completed, the trench extending into the second source/drain region SD2 may be defined as the second contact trench CT2 between the insulating liner layers 160.

Referring to FIGS. 2 to 4, a lower source/drain contact BCA may be formed inside the second contact trench (CT2 of FIGS. 34 and 35). Also, a lower silicide layer BSL may be formed between the lower source/drain contact BCA and the second source/drain region SD2. The semiconductor device shown in FIG. 2 to FIG. 4 may be manufactured through such a fabricating process.

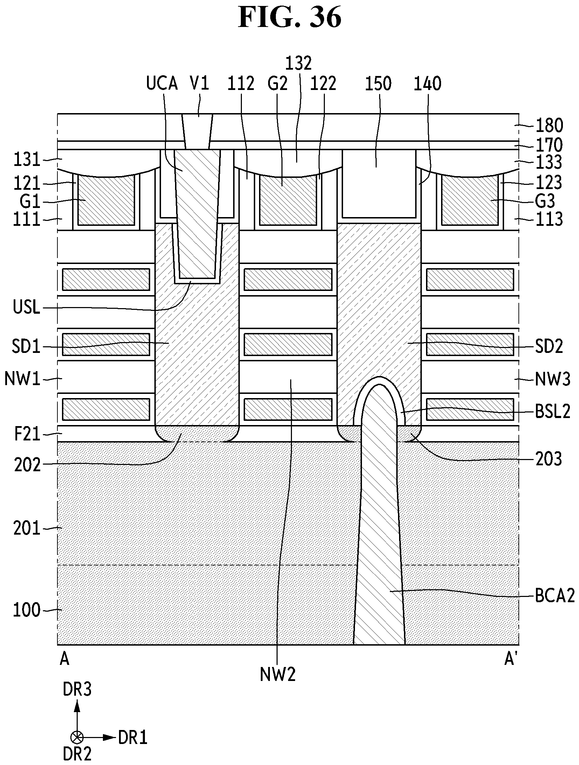

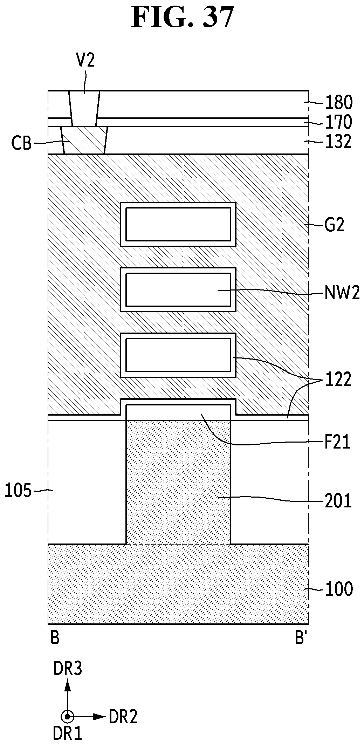

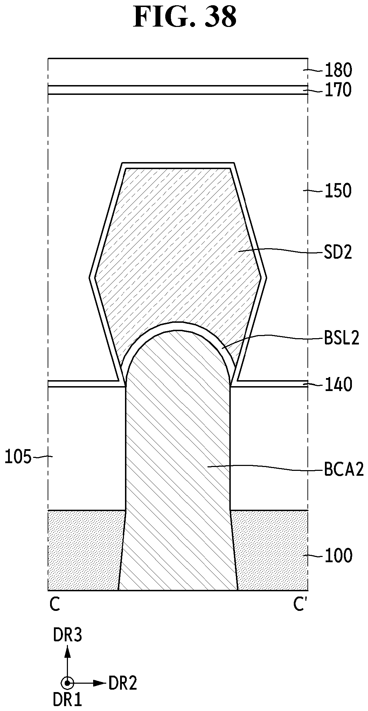

Hereinafter, a semiconductor device according to some other embodiments of the present disclosure will be described with reference to FIGS. 36 to 38. The differences from the semiconductor device shown in FIG. 1 to FIG. 4 will be described.

FIGS. 36 to 38 are cross-sectional views illustrating a semiconductor device according to some other embodiments of the present disclosure.

Referring to FIGS. 36 to 38, in the semiconductor device according to some other embodiments of the present disclosure, both side walls of the lower source/drain contact BCA2 in the first horizontal direction DR1 may be in contact with each of the lower interlayer insulating layer 100, the insulating pattern 201 and the second buried insulating pattern 203.

For example, the lower surface of the active pattern F21 may be formed on the same plane as the upper surface of the field insulating layer 105. For example, the lower surface of the active pattern F21 may be formed on the same plane as each of the lower surface of the first buried insulating pattern 202 and the lower surface of the second buried insulating pattern 203. For example, the upper surface of the insulating pattern 201 may be formed on the same plane as the upper surface of the field insulating layer 105. For example, the upper surface of the insulating pattern 201 may be in contact with the lower surface of the second buried insulating pattern 203. For example, the lower source/drain contact BCA2 may be separated from the active pattern F21 by the second buried insulating pattern 203. For example, the lower surface of the lower silicide layer BSL2 may be in contact with the upper surface of the second buried insulating pattern 203.

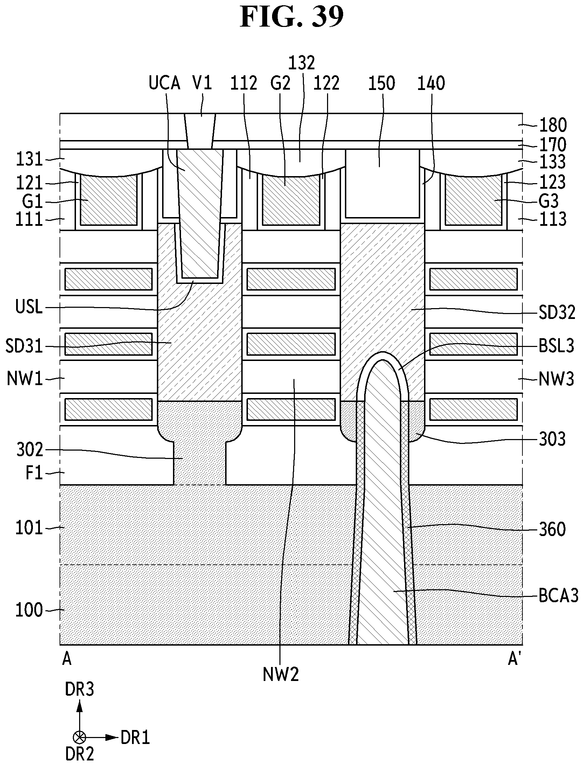

Hereinafter, a semiconductor device according to some other embodiments of the present disclosure will be described with reference to FIG. 39. Differences from the semiconductor device shown in FIGS. 1 to 4 will be described.

FIG. 39 is a cross-sectional view illustrating a semiconductor device according to some other embodiments of the present disclosure.

Referring to FIG. 39, in the semiconductor device according to the other embodiment of the present disclosure, each of the upper surface of the first buried insulating pattern 302 and the upper surface of the second buried insulating pattern 303 may be formed to be higher than the upper surface of the active pattern F1 in the vertical direction DR3.

For example, each of the upper surface of the first buried insulating pattern 302 and the upper surface of the second buried insulating pattern 303 may be formed to be lower than the lower surface of the lowest nanosheet of the second plurality of nanosheets NW2 in the vertical D3 direction. For example, each of the lower surface of the first source/drain region SD31 and the lower surface of the second source/drain region SD32 may be formed to be higher than the upper surface of the active pattern F1 in the vertical D3 direction. For example, the insulating liner layer 360 may be disposed between the lower source/drain contact BCA3 and the second buried insulating pattern 303. For example, the upper surface of the insulating liner layer 360 may be formed on the same plane as the upper surface of the second buried insulating pattern 303. For example, the upper surface of the insulating liner layer 360 may be formed to be lower than the lower surface of the lowermost nanosheet of the second plurality of nanosheets NW2 in the D3 direction. For example, the lower silicide layer BSL3 may be in contact with the upper surface of the insulating liner layer 360.

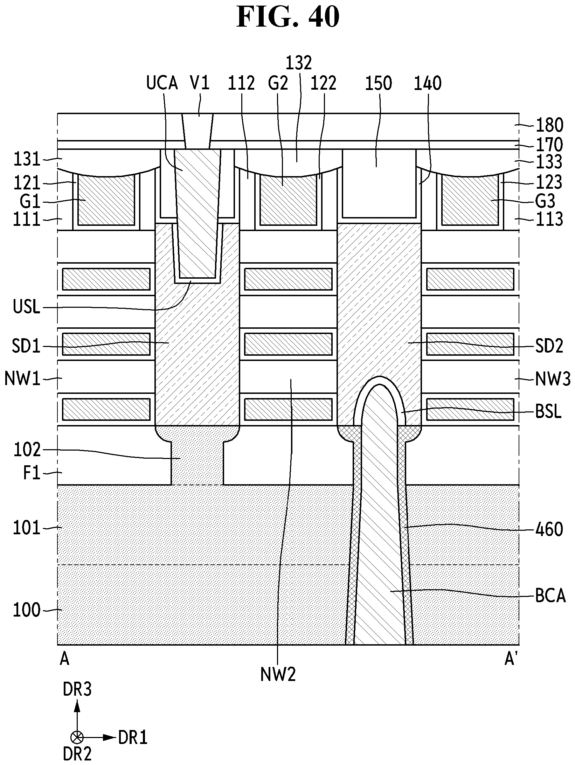

Hereinafter, a semiconductor device according to still other embodiments of the present disclosure will be described with reference to FIG. 40. Differences from the semiconductor device shown in FIGS. 1 to 4 will be described.

FIG. 40 is a cross-sectional view illustrating a semiconductor device according to still other embodiments of the present disclosure.

Referring to FIG. 40, in the semiconductor device according to still other embodiments of the present disclosure, the second buried insulating pattern (103 of FIG. 2) is not disposed below the second source/drain region SD2 in the vertical D3 direction.

For example, the upper surface of the insulating liner layer 460 may be in contact with each of the lower surface of the lower silicide layer BSL and the lower surface of the second source/drain region SD2. For example, the upper surface of the insulating liner layer 460 may be formed on the same plane as the upper surface of the active pattern F1. For example, the active pattern F1 and the second source/drain region SD2 may be separated by the insulating liner layer 460. That is, the active pattern F1 and the second source/drain region SD2 may be electrically insulated by the insulating liner layer 460.

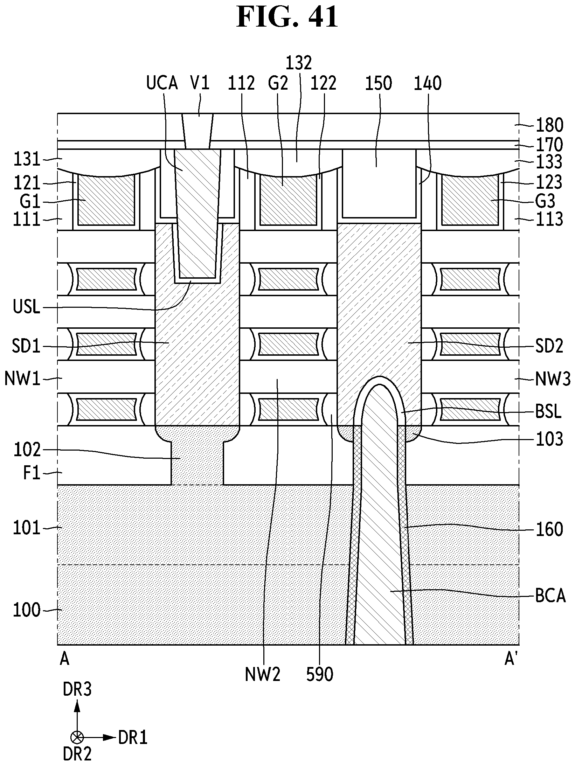

Hereinafter, a semiconductor device according to some other embodiments of the present disclosure will be described with reference to FIG. 41. Differences from the semiconductor device shown in FIG. 1 to FIG. 4 will be described.

FIG. 41 is a cross-sectional view illustrating a semiconductor device according to some other embodiments of the present disclosure.

Referring to FIG. 41, in the semiconductor device according to some other embodiments of the present disclosure, an inner spacer 590 may be disposed between each of the first and second gate electrodes G1 and G2 and the first source/drain region SD1, and between each of the second and third gate electrodes G2 and G3 and the second source/drain region SD2.

For example, the inner spacers 590 may be disposed on both side walls of the first gate electrode G1 in the first horizontal direction DR1 between the upper surface of the active pattern F1 and the lower surface of the lowermost nanosheets of each of the first plurality of nanosheets NW1. The inner spacers 590 may be disposed on both side walls of the second gate electrode G2 in the first horizontal direction DR1 between the upper surface of the active pattern F1 and the lower surface of the lowermost nanosheets of each of the second plurality of nanosheets NW2. The inner spacers 590 may be disposed on both side walls of the third gate electrode G3 in the first horizontal direction DR1 between the upper surface of the active pattern F1 and the lower surface of the lowermost nanosheets of each of the third plurality of nanosheets NW3.

For example, the inner spacers 590 may be disposed on both side walls of the first gate electrode G1 in the first horizontal direction DR1 between the first plurality of nanosheets NW1. The inner spacers 590 may be disposed on both side walls of the second gate electrode G2 in the first horizontal direction DR1 between the second plurality of nanosheets NW2. The inner spacers 590 may be disposed on both side walls of the third gate electrode G3 in the first horizontal direction DR1 between the third plurality of nanosheets NW3.

For example, the inners spacer 590 may be in contact with each of the first to third gate insulating layers 121, 122 and 123. For example, the inner spacers 590 may be in contact with each of the first and second source/drain regions SD1 and SD2. For example, the inner spacers may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof.

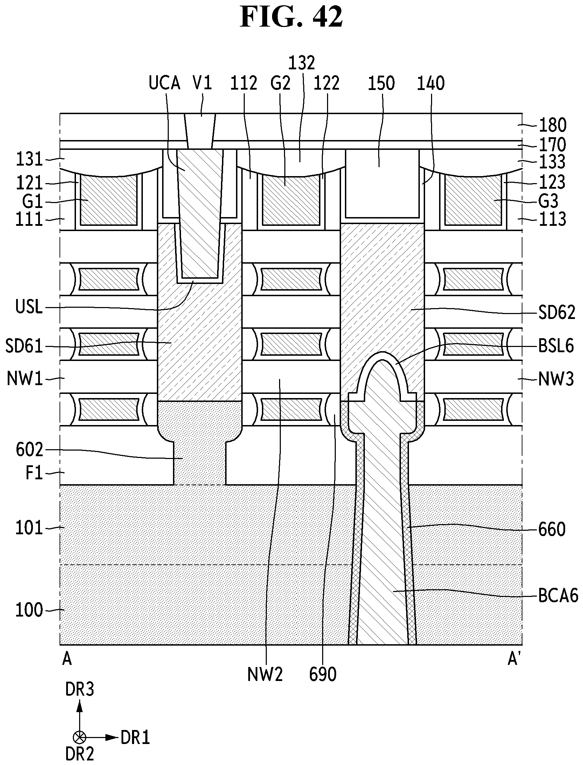

Hereinafter, a semiconductor device according to some other embodiments of the present disclosure will be described with reference to FIG. 42. Differences from the semiconductor device shown in FIGS. 1 to 4 will be described.

FIG. 42 is a cross-sectional view illustrating a semiconductor device according to still other embodiments of the present disclosure.

Referring to FIG. 42, in the semiconductor device according to some other embodiments of the present disclosure, an inner spacer 690 is disposed between each of the first and second gate electrodes G1 and G2 and the first source/drain region SD61, and between each of the second and third gate electrodes G2 and G3 and the second source/drain region SD62, and an insulating liner layer 660 may be in contact with the inner spacers 690.

For example, the inner spacers 690 may be disposed on both side walls of the first gate electrode G1 in the first horizontal direction DR1 between the upper surface of the active pattern F1 and the lower surface of the lowermost nanosheet of each of the first plurality of nanosheets NW1. The inner spacers 690 may be disposed on both side walls of the second gate electrode G2 in the first horizontal direction DR1 between the upper surface of the active pattern F1 and the lower surface of the lowermost nanosheet of each of the second plurality of nanosheets NW2. The inner spacers 690 may be disposed on both side walls of the third gate electrode G3 in the first horizontal direction DR1 between the upper surface of the active pattern F1 and the lower surface of the lowermost nanosheet of each of the third plurality of nanosheets NW3.

For example, the inner spacers 690 may be disposed on both side walls of the first gate electrode G1 in the first horizontal direction DR1 between the first plurality of nanosheets NW1. The inner spacers 690 may be disposed on both side walls of the second gate electrode G2 in the first horizontal direction DR1 between the second plurality of nanosheets NW2. The inner spacers 690 may be disposed on both side walls of the third gate electrode G3 in the first horizontal direction DR1 between the third plurality of nanosheets NW3.

For example, the inner spacers 690 may be in contact with each of the first to third gate insulating layers 121, 122 and 123. For example, the inner spacers 690 may be in contact with each of the first and second source/drain regions SD61 and SD62. For example, the inner spacers may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof

For example, the upper surface of the first buried insulating pattern 602 may be formed to be higher than the upper surface of the active pattern F1 in the vertical direction DR3. For example, the upper surface of the first buried insulating pattern 602 may be formed to be lower than the lower surface of the lowermost nanosheet of the second plurality of nanosheets NW2 in the vertical direction DR3. For example, each of the lower surface of the first source/drain region SD61 and the lower surface of the second source/drain region SD62 may be formed to be higher than the upper surface of the active pattern F1 in the vertical direction DR3. For example, the insulating liner layer 660 may be disposed between the lower source/drain contact BCA6 and the inner spacer 690. For example, the insulating liner layer 660 may be in contact with the inner spacer 690. For example, the upper surface of the insulating liner layer 660 may be formed to be lower than the lower surface of the lowermost nanosheet of the second plurality of nanosheets NW2 in the vertical direction DR3. For example, the lower silicide layer BSL6 may be disposed between the lower source/drain contact BCA6 and the second source/drain region SD62. For example, the active pattern F1 and the second source/drain region SD62 may be separated by the insulating liner layer 660. That is, the active pattern F1 and the second source/drain region SD62 may be electrically insulated by the insulating liner layer 660.

Although the embodiments of the present disclosure have been described above with reference to the accompanying drawings, the present disclosure is not limited to the above embodiments, and may be fabricated in various different forms. Those skilled in the art will appreciate that the present disclosure may be embodied in other specific forms without changing the technical scope or features of the present disclosure. Accordingly, the above-described embodiments should be understood in all respects as illustrative

## Claims

1. A semiconductor device comprising:
a lower interlayer insulating layer;
an insulating pattern extending in a first direction on an upper surface of the lower interlayer insulating layer;
an active pattern extending in the first direction on an upper surface of the insulating pattern, the active pattern including silicon;
a plurality of nanosheets spaced apart from each other and stacked in a third direction on an upper surface of the active pattern;
a gate electrode extending in a second direction on the upper surface of the active pattern, the gate electrode surrounding the plurality of nanosheets, in a cross-sectional view of the semiconductor device taken along the first direction, the first and second directions being perpendicular to one another and forming a plane, the third direction being perpendicular to the plane;
a first source/drain region on a first side of the gate electrode;
a second source/drain region on a second side of the gate electrode opposite to the first side of the gate electrode in the first direction, at least a part of the second source/drain region overlapping the active pattern in the third direction, the second source/drain region not being in contact with the active pattern; and
a lower source/drain contact extending through the lower interlayer insulating layer, the insulating pattern, and the active pattern in the third direction, the lower source/drain contact being electrically connected to the second source/drain region.

2. The semiconductor device of claim 1, further comprising:
a first buried insulating pattern being in contact with each of the upper surface of the insulating pattern and a lower surface of the first source/drain region, both side walls of the first buried insulating pattern in the first direction being in contact with the active pattern, the first buried insulating pattern including a same material as the insulating pattern.

3. The semiconductor device of claim 2, wherein an upper surface of the first buried insulating pattern is formed on a same plane as the upper surface of the active pattern.

4. The semiconductor device of any preceding claim, further comprising:
a field insulating layer surrounding a side wall of the insulating pattern and a side wall of the active pattern in a plan view of the semiconductor device on the upper surface of the lower interlayer insulating layer.

5. The semiconductor device of any preceding claim, further comprising:
an upper source/drain contact on the first source/drain region, the upper source/drain contact being electrically connected to the first source/drain region.

6. The semiconductor device of any preceding claim, further comprising:
a second buried insulating pattern on both side walls of the lower source/drain contact in the first direction, the second buried insulating pattern being in contact with each of a lower surface of the second source/drain region and the active pattern, the second buried insulating pattern not overlapping the plurality of nanosheets in the third direction, the second buried insulating pattern including a same material as the insulating pattern.

7. The semiconductor device of claim 6, wherein an upper surface of the second buried insulating pattern is formed on a same plane as the upper surface of the active pattern.

8. The semiconductor device of any preceding claim, further comprising:
an insulating liner layer surrounding a side wall of the lower source/drain contact in a plan view of the semiconductor device on a lower surface of the second source/drain region, the insulating liner layer including a material different from each of the lower interlayer insulating layer and the insulating pattern.

9. The semiconductor device of claim 8, further comprising:
a lower silicide layer between the lower source/drain contact and the second source/drain region, the lower silicide layer being in contact with an upper surface of the insulating liner layer.

10. The semiconductor device of claim 8, wherein the upper surface of the insulating liner layer is in contact with the second source/drain region.

11. The semiconductor device of any preceding claim, further comprising:
an inner spacer on both side walls of the gate electrode in the first direction, between the upper surface of the active pattern and a lower surface of a lowermost nanosheet of the plurality of nanosheets.

12. The semiconductor device of claim 11, further comprising:
an insulating liner layer surrounding a side wall of the lower source/drain contact in a plan view of the semiconductor device on a lower surface of the second source/drain region, the insulating liner layer being in contact with a side wall of the inner spacer.

13. A semiconductor device comprising:
a lower interlayer insulating layer;
an insulating pattern extending in a first direction on an upper surface of the lower interlayer insulating layer;
an active pattern extending in the first direction on an upper surface of the insulating pattern, the active pattern including silicon;
a field insulating layer surrounding a side wall of the insulating pattern and a side wall of the active pattern on the upper surface of the lower interlayer insulating layer in a plan view of the semiconductor device;
a gate electrode extending in a second direction on an upper surface of the active pattern and an upper surface of the field insulating layer, the first and second directions being perpendicular to one another and forming a plane;
a first source/drain region on a first side of the gate electrode;
a second source/drain region on a second side of the gate electrode opposite to the first side of the gate electrode in the first direction, the second source/drain region not being in contact with on the active pattern;
a lower source/drain contact extending through the lower interlayer insulating layer, the insulating pattern, and the active pattern in a third direction that is perpendicular to the plane, the lower source/drain contact being electrically connected to the second source/drain region;
a first buried insulating pattern being in contact with each of the upper surface of the insulating pattern and a lower surface of the first source/drain region, both side walls of the first buried insulating pattern in the first direction being in contact with the active pattern, the first buried insulating pattern including a same material as the insulating pattern; and
a second buried insulating pattern on both side walls of the lower source/drain contact in the first direction, the second buried insulating pattern being in contact with each of a lower surface of the second source/drain region and the active pattern, the second buried insulating pattern including a same material as the insulating pattern.

14. The semiconductor device of claim 13, wherein at least a part of the first source/drain region overlaps the active pattern in the third direction, and the first source/drain region is not in contact with the active pattern.

15. The semiconductor device of claim 13 or claim 12, wherein both side walls of the lower source/drain contact in the first direction are in contact with each of the lower interlayer insulating layer, the insulating pattern, and the second buried insulating pattern.
